# EUROPEAN PATENT SPECIFICATION

(11) **EP 3 321 977 B1**
(45) Date of publication and mention of the grant of the patent: **20.02.2019**
(21) Application number: 17196398.6
(22) Date of filing: 13.10.2017
(51) Int. Cl.: H01L 31/072, H01L 31/074, H01L 31/0216, H01L 31/0224, H01L 31/18, H01L 31/0236

(54) **SOLAR CELL AND METHOD FOR MANUFACTURING THE SAME**
SOLARZELLE UND VERFAHREN ZU DEREN HERSTELLUNG
CELLULE SOLAIRE ET SON PROCÉDÉ DE FABRICATION

(30) Priority: 14.11.2016 KR 20160151126
(43) Date of publication of application: 16.05.2018
(73) Proprietor: LG Electronics Inc., Seoul 07336 (KR)
(72) Inventor: LEE, Yujin, Seoul 08592 (KR); KWON, Taein, Seoul 08592 (KR); JI, Kwangsun, Seoul 08592 (KR); LEE, Hongcheol, Seoul 08592 (KR)
(74) Representative: Katérle, Axel

(56) References cited:
- EP-A1- 3 070 750
- US-A1- 2013 214 271
- US-A1- 2016 020 342
- BETHGE O ET AL: "ALD grown bilayer junction of ZnO:Al and tunnel oxide barrier for SIS solar cell", SOLAR ENERGY MATERIALS AND SOLAR CELLS, vol. 117, 2013, pages 178-182, XP028708612, ISSN: 0927-0248, DOI: 10.1016/J.SOLMAT.2013.04.028

## Description

### TECHNICAL FIELD

Embodiments of the invention relate to a solar cell and a method for manufacturing the same, and, more particularly, to a solar cell including a metal oxide and a method for manufacturing the same.

### BACKGROUND

Recently, as existing energy resources such as petroleum and coal are expected to be depleted, interest in alternative energy to replace them is increasing. Among them, solar cells are attracting attention as a next-generation battery that converts solar energy into electric energy.

Such a solar cell may be manufactured by forming various layers and various electrodes according to desired designs. In connection with this, efficiency of the solar cell may be determined according to designs of the various layers and electrodes. For commercial availability of such a solar cell, it is necessary to overcome problems associated with low efficiency of the solar cell. Accordingly, the various layers and the various electrodes are needed to be designed and manufactured in order to maximize the efficiency of the solar cell.

For example, in a conventional solar cell manufactured by doping a semiconductor substrate with a dopant, a doping process and the like are very complicated, and interfacial properties of the semiconductor substrate are deteriorated, resulting in poor passivation properties. In another solar cell manufactured without the doping process of the semiconductor substrate with the dopant in order to prevent this, properties and efficiency of the solar cell may be largely changed depending on the properties of a layer included in the solar cell and reliability of the solar cell is not high.

US 2016/0020342 A1 discloses a solar cell with an interdigitated back contact, comprising first and second conductive oxide materials electrically coupled to a crystalline silicon base layer.

### SUMMARY

Therefore, the invention has been made in view of the above problems, and the invention is to provide a solar cell having excellent and uniform efficiency and properties and high productivity, and a method for manufacturing the solar cell.

A solar cell in accordance with claim 1 includes: a semiconductor substrate; a tunneling layer on a surface of the semiconductor substrate; an intermediate layer on the tunneling layer, wherein the intermediate layer including a hydroxyl group (an OH

group); a first conductive region on the intermediate layer, wherein the first conductive region comprising a metal oxide layer for extracting a first carrier; and a first electrode electrically connected to the first conductive region.

A method for manufacturing a solar cell includes in accordance with claim 10: forming a tunneling layer on a surface of a semiconductor substrate; forming an intermediate layer including a hydroxyl group (an OH group) on the tunneling layer; forming a first conductive region comprising a metal oxide layer for extracting a first carrier on the intermediate layer; and forming a first electrode electrically connected to the first conductive region.

According to the invention, since an intermediate layer is positioned between a tunneling layer and a conductive region and thus changes surface properties, the conductive region can be formed with a stable and uniform thickness. Further, the intermediate layer acts as a capping layer or a barrier buffer layer, thereby preventing degradation of surface passivation properties. As a result, efficiency and reliability of the solar cell can be improved. This solar cell is formed by a simple process, and thus, productivity of the solar cell can be enhanced.

### BRIEF DESCRIPTION OF THE DRAWINGS

The above and other objects, features and other advantages of the invention will be more clearly understood from the following detailed description taken in conjunction with the accompanying drawings, in which:
FIG. 1 is a cross-sectional view of a solar cell according to an embodiment of the invention;
FIG. 2 is a front plan view of the solar cell shown in FIG. 1;
FIG. 3 shows a band diagram of a semiconductor substrate, a second tunneling layer, and a second conductive region in a solar cell according to an embodiment of the invention in (a), and a band diagram of the semiconductor substrate, a first tunneling layer, and a first conductive region in the solar cell according to the embodiment of the invention in (b);
FIG. 4 is a cross-sectional view of a solar cell according to a modified embodiment of the invention;
FIGs. 5a to 5d are cross-sectional views showing a method for manufacturing a solar cell according to an embodiment of the invention;
FIG. 6 is a cross-sectional view of a solar cell according to another embodiment of the invention;
FIG. 7 is a rear plan view of the solar cell shown in FIG. 6;
FIG. 8 is a transmission electron microscope (TEM) photograph of a solar cell according to Embodiment 1;
FIG. 9 is a transmission electron microscope photograph of a solar cell according to Comparative Example 1; and
FIG. 10 is a graph showing implied open-circuit voltages (implied Vocs) of the solar cells according to Embodiment 1 and Comparative Example 1.

### DETAILED DESCRIPTION

Reference will now be made in detail to various embodiments of the invention, examples of which are illustrated in accompanying drawings. The invention may, however, be embodied in many alternate forms and should not be construed as limited to the embodiments set forth herein.

In the drawings, illustration of parts unrelated to embodiments of the invention is omitted for clarity and simplicity of description. The same reference numerals designate the same or very similar elements throughout the specification. In the drawings, the thicknesses, widths or the like of elements are exaggerated or reduced for clarity of description, and should not be construed as limited to those illustrated in the drawings.

It will be understood that the terms "comprises" and/or "comprising," or "includes" and/or "including" used in the specification specify the presence of stated elements, but do not preclude the presence or addition of one or more other elements. In addition, it will be understood that, when an element such as a layer, film, region, or plate is referred to as being "on" another element, it may be directly disposed on another element or may be disposed such that an intervening element is also present therebetween. Accordingly, when an element such as a layer, film, region, or plate is disposed "directly on" another element, this means that there is no intervening element between the elements.

Also, hereinafter, terms "first" and "second" are used only for distinguishing each other, and the embodiments of the invention are not limited thereto.

Hereinafter, a solar cell and a method for manufacturing the same according to embodiments of the invention will be described in detail with reference to the accompanying drawings.

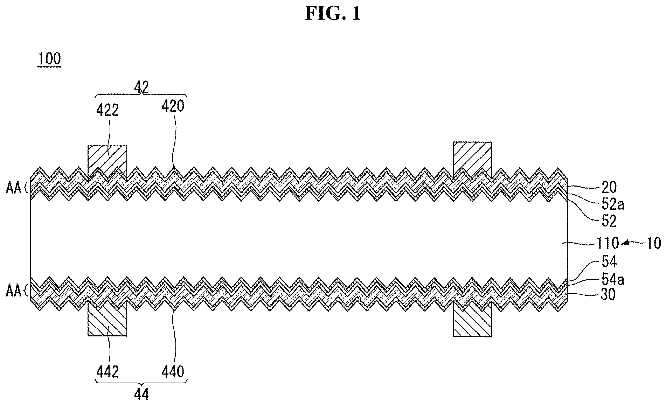

FIG. 1 is a cross-sectional view of a solar cell according to an embodiment of the invention.

Referring to FIG. 1, a solar cell 100 according to the embodiment includes a semiconductor substrate 10, a first tunneling layer 52 on a surface of the semiconductor substrate 10, a first intermediate layer 52a including a hydroxyl group (an OH group) on the first tunneling layer 52, a first conductive region 20 comprising a metal oxide layer (for example, a binary metal oxide layer) for extracting a first carrier on the first tunneling layer 52, and a first electrode 42 electrically connected to the first conductive region 20. Also, the solar cell 100 may include a second conductive region 30 and a second electrode 44 electrically connected to the second conductive region 30. This will be explained in more detail.

The semiconductor substrate 10 may include a base region 110 having a first or second conductivity type. The base region 110 may have a first or second conductivity type dopant with a relatively low doping concentration. The base region 110 may be formed of a single crystalline semiconductor (e.g., a single-crystalline or polycrystalline semiconductor of a single material, such as a single-crystalline or polycrystalline silicon, more particularly, a single-crystalline silicon) including an n-type or p-type dopant. The solar cell 100 based on the semiconductor substrate 10 or the base region 110 having a high degree of crystallinity and having few defects has excellent electrical properties. In the embodiment, the semiconductor substrate 10 may be formed of only the base region 110 without a doped region formed by additional doping or the like. As a result, it is possible to prevent degradation of passivation properties of the semiconductor substrate 10 due to the doped region.

As an example, in the embodiment, the base region 110 may be doped with an n-type dopant to have an n-type. If the base region 110 has the n-type, a metal oxide layer (for example, a binary metal oxide layer) used as the first and second conductive regions 20 and 30 may be formed of a material that can be easily obtained and can be easily formed. Specific materials of the first and second conductive regions 20 and 30 will be described later in detail.

An anti-reflection structure capable of minimizing reflection may be formed on front and back surfaces of the semiconductor substrate 10. For example, a texturing structure having a concavo-convex shape in the form of a pyramid or the like may be provided as the anti-reflection structure. The texturing structure formed on the semiconductor substrate 10 may have a certain shape (e.g., a pyramid shape) having an outer surface formed along a specific crystal plane (e.g., (111) plane) of a semiconductor. When the surface roughness of the semiconductor substrate 10 is increased by forming concaves and convexes on the front surface and so on of the semiconductor substrate 10 by such texturing, the reflectivity of light incident into the semiconductor substrate 10 can be reduced to minimize the optical loss. However, the embodiments of the invention are not limited thereto. A texturing structure may be formed on only one surface of the semiconductor substrate 10, or a texturing structure may not be formed on the front and back surfaces of the semiconductor substrate 10.

The first tunneling layer 52 is formed on (e.g., is in contact with) the front surface of the semiconductor substrate 10. The first tunneling layer 52 acts as a kind of a barrier to electrons and holes so that minority carriers do not pass and only majority carriers having energy above a certain level can pass through the first tunneling layer 52 after the majority carriers are accumulated at a portion adjacent to the first tunneling layer 52. In this instance, the majority carriers having energy equal to or greater than the certain level can easily pass through the first tunneling layer 52 by a tunneling effect. The first tunneling layer 52 may improve passivation properties of the surface of the semiconductor substrate 10.

The first tunneling layer 52 may be formed entirely on the front surface of the semiconductor substrate 10. Accordingly, the first tunneling layer 52 can be easily formed without any additional patterning while having excellent passivation properties. The first tunneling layer 52 may be an undoped layer having no dopant. In the embodiment, since the first conductive region 20 is formed of a binary metal oxide layer not including the dopant and the first tunneling layer 52 may be relatively thick, the dopant included in the first conductive region 20 may be not diffused to the first tunneling layer 52 or the semiconductor substrate 10. Therefore, the first tunneling layer 52 may be formed the undoped layer.

The first tunneling layer 52 may include any of various materials through which the majority carriers can be transferred by a tunneling. For example, the first tunneling layer 52 may include any of an oxide, a nitride, a semiconductor, a conductive polymer, and the like. For example, the first tunneling layer 52 may include a silicon oxide, a silicon nitride, a silicon oxynitride, a silicon carbide, an intrinsic amorphous semiconductor, an intrinsic polycrystalline semiconductor, and the like. In particular, the first tunneling layer 52 may be formed of a silicon oxide layer including a silicon oxide. This is because the silicon oxide layer is a layer which is excellent in passivation properties and through which the carrier can be easily transferred by the tunneling. Such a silicon oxide layer may be formed by a thermal oxidation or a chemical oxidation. Alternatively, the first tunneling layer 52 may be formed of an intrinsic amorphous silicon (i-a-Si) layer. Then, the first tunneling layer 52 includes the same material with the semiconductor substrate 10 and the first tunneling layer 52 has similar properties to the semiconductor substrate 10, and the first tunneling layer 52 may be easily hydrogenated. Thus, the passivation properties can be improved more effectively. However, the embodiments of the invention are not limited thereto. Accordingly, the first tunneling layer 52 may be formed of an intrinsic amorphous silicon carbide (i-a-SiCx) layer or an intrinsic amorphous silicon oxide (i-a-SiOx) layer. According to this, the effect due to the wide energy band gap can be achieved, but the passivation property may be lower to some degrees than the embodiment including the intrinsic amorphous silicon (i-a-Si) layer.

The first intermediate layer 52a may be positioned on (e.g., be in contact with) the first tunneling layer 52. The first intermediate layer 52a may change surface properties so that the first conductive region 20 formed thereon can have a desired crystal structure (i.e., an amorphous structure). The first intermediate layer 52a may be entirely formed on the first tunneling layer 52 to entirely change the surface properties of the surface on which the first conductive region 20 is formed. This will be described in more detail after describing the first conductive region 20.

The first conductive region 20 may be positioned on (e.g., be in contact with) the first intermediate layer 52a. The first conductive region 20 may be formed entirely on the first intermediate layer 52a. Accordingly, the first conductive region 20 has a sufficient area, and thus, an area contributing to the photoelectric conversion can be maximized. In the embodiment, the first conductive region 20 includes a metal oxide layer having an amorphous structure, which will be described later in more detail.

A thickness of the first tunneling layer 52 may be equal to, less than, or greater than a thickness of the first conductive region 20. In the embodiment, the first conductive region 20 may be formed of a binary metal oxide layer having an amorphous structure, and the amorphous structure of the first conductive region 20 may be formed and maintained when the first conductive region 20 is thin. Accordingly, the first conductive region 20 has a small thickness in the embodiment, and thus, the thickness of the first tunneling layer 52 in not limited to be less than the thickness of the first conductive region 20. For example, when the thickness of the first conductive region 20 is minimized so that the first conductive region 20 has a more stable amorphous structure, the thickness of the first conductive region 20 may be equal to or less than the thickness of the first tunneling layer 52. As another example, when the thickness of the first tunneling layer 52 is reduced to maximize the tunneling effect through the first tunneling layer 52, the thickness of the first tunneling layer 52 may be less than the thickness of the first conductive region 20.

Alternatively, the thickness of the first tunneling layer 52 may be 10 nm or less, and the thickness of the first conductive region 20 may be 30 nm or less (for example, 10 nm or less). If the thickness of the first tunneling layer 52 exceeds 10 nm, the tunneling does not occur smoothly, and the solar cell 100 may not operate smoothly. If the thickness of the first conductive region 20 is greater than 30 nm, it may be difficult to have an amorphous structure and the carrier may not flow smoothly due to low electrical conductivity. In this instance, when the first conductive region 20 has a thickness of 10 nm or less, the amorphous structure of the first conductive region 20 can be stably maintained.

For example, the thickness of the first tunneling layer 52 may be 5 nm or less (more particularly, 2 nm or less, for example, 0.5 nm to 2 nm) in order to sufficiently realize the tunneling effect. If the thickness of the first tunneling layer 52 is less than 0.5 nm, it may be difficult to form the first tunneling layer 52 of desired quality. The first conductive region 20 may have the thickness of 2 nm or more (for example, 5 nm or more) so as to stably act as the conductive region. However, the embodiments of the invention are not limited thereto, and the thickness of the first tunneling layer 52 and/or the thickness of the first conductive region 20 may have any of various values.

The first electrode 42 may be formed on (e.g., be in contact with) the first conductive region 20 to be electrically connected to the first conductive region 20. For example, the first electrode 42 may include a first transparent electrode layer 420 and a first metal electrode layer 422 that are sequentially stacked on the first conductive region 20.

In this instance, the first transparent electrode layer 420 may be formed on (e.g., be in contact with) the first conductive region 20 to have a relatively large area. For example, the first transparent electrode layer 420 may be formed entirely on the first conductive region 20. When the first transparent electrode layer 420 is formed on the first conductive region 20 as described above, the carrier can easily reach the first metal electrode layer 422 through the first transparent electrode layer 420, and thus, resistance in a lateral direction can be reduced. In particular, in the embodiment, the first conductive region 20 is formed of an undoped metal compound layer that does not include a dopant, and thus, the resistance of the first conductive region may be increased. Therefore, the first transparent electrode layer 420 may be provided to effectively reduce the resistance.

As described above, since the first transparent electrode layer 420 is formed on the first conductive region 20 with a wide area, the first transparent electrode layer 420 may be formed of a light-transmitting material (a transparent material). That is, the first transparent electrode layer 420 may be formed of a transparent conductive material or a transparent conductive oxide so that the carrier can be easily moved while allowing transmission of light. Accordingly, even if the first transparent electrode layer 420 is formed on the first conductive region 20 with a large area, the transmission of light is not blocked. For example, the first transparent electrode layer 420 may include indium tin oxide (ITO), carbon nanotube (CNT), or the like. However, the embodiments of the invention are not limited thereto, and the first transparent electrode layer 420 may include any of various other materials.

The first metal electrode layer 422 may be formed on the first transparent electrode layer 420. For example, the first metal electrode layer 422 may be in contact with the first transparent electrode layer 420 to simplify the structure of the first electrode 42. However, the embodiments of the invention are not limited to this, and various modifications such as there is a separate layer between the first transparent electrode layer 420 and the first metal electrode layer 422 are possible.

The first metal electrode layer 422 located on the first transparent electrode layer 420 may be formed of a material having electrical conductivity superior to that of the first transparent electrode layer 420. Thus, properties such as carrier collection efficiency can be further improved and the resistance can be effectively reduced by the first metal electrode layer 422. For example, the first metal electrode layer 422 may be formed of a material having an electrical conductivity higher than that of the first transparent electrode layer 420. The material of the first metal electrode layer 422 may be an opaque metal or a metal having transparency lower than that of the first transparent electrode layer 420.

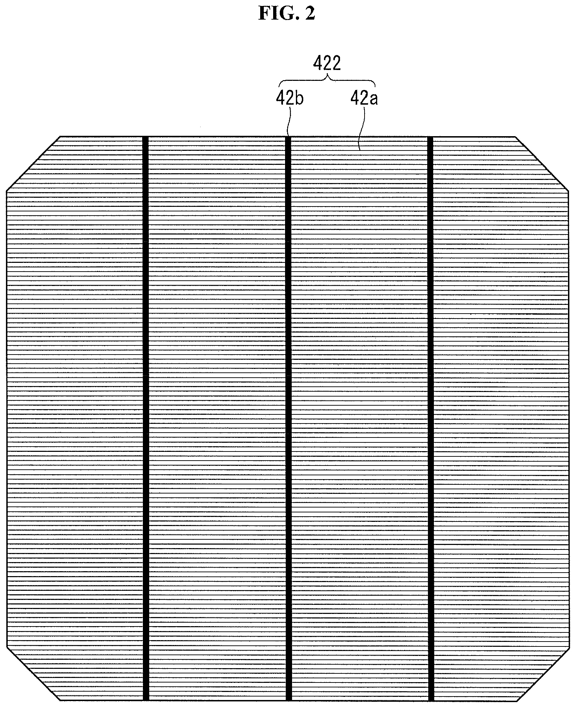

Since the first metal electrode layer 422 is opaque or has low transparency, it may interfere with the incidence of light, so that it may have a certain pattern so as to minimize shading loss. The first metal electrode layer 422 has a smaller area than the first transparent electrode layer 420. Thus, light can be incident on a portion where the first metal electrode layer 422 is not formed. A planar shape of the first metal electrode layer 422 will be described later in more detail with reference to FIG. 2.

In the embodiment, since the first metal electrode layer 422 is formed adjacent to or in contact with the first transparent electrode layer 420, a fire-through penetrating an insulating layer or the like is not required. The first metal electrode layer 422 may be formed by coating (e.g., by printing) a low-temperature-firing paste that can be fired at a low temperature (350°C or less, for example, 300°C or less, as an example, 250°C or less) and heat-treating it.

The low-temperature-firing paste or the first metal electrode layer 422 formed by using the low-temperature-firing paste may not include a glass frit formed of a certain metal compound (for example, an oxide containing oxygen, a carbide containing carbon, a sulfide containing sulfur). The low-temperature-firing paste or the first metal electrode layer 422 may include only metal particles and a cross-linking resin, and other resins (for example, a curing agent, an additive). When the low-temperature-firing paste or the first metal electrode layer 422 does not include the glass frit, the metal particles of the first metal electrode layer 422 are not sintered. Instead, the first metal electrode layer 422 has the electrical conductivity since the low-temperature-firing paste is cured. In the curing process, the metal particles of the first metal electrode layer 422 are in contact with and aggregated with each other.

The metal particles may include any of various materials that provide the electrical conductivity. For example, the metal particles may include one selected from a group consisting of silver (Ag) particles, aluminum (Al) paticles, copper (Cu) particles, or silver, aluminum, or copper particles coated with silver or tin (Sn), or include two or more particles selected from the above group and mixed to each other.

The cross-linking resin may include a material capable of performing cross-linking between the metals. In the embodiment, the first metal electrode layer 422 may be an electrode layer to which a solder layer for bonding a wiring material or the like is attached. The cross-linking resin may also prevent a penetration of the solder layer. Unlike the embodiment, if the cross-link resin is not included, the solder layer may penetrate into the first metal electrode layer 422 and the first metal electrode layer 422 may have brittleness, and thus, the first metal electrode layer 422 may be be easily broken by a small impact or the like. It is expected that the cross-linking resin fills between the metal particles to prevent the penetration of the solder layer in the embodiment. For example, the cross-linking resin may include any of a phenoxy-based resin, an epoxy-based resin, a cellulose-based resin, and the like. They are excellent in cross-linking properties and do not change the properties of electrodes. In particular, when the epoxy-based resin is used, excellent cross-linking properties can be obtained. In addition, the first metal electrode layer 422 may further include a curing agent. As the curing agent, an amine-based curing agent may be used. Examples of the amine-based curing agent may be any of phthalic anhydride, diethylamino propylamine, diethylene triamine, and the like. In addition, the other additives and the like may be included.

The low-temperature-firing paste for forming the first metal electrode layer 422 includes a solvent. However, the solvent may be volatilized during the heat treatment and may not be included in the first metal electrode layer 422 or may be included in a very small amount. As the solvent, an organic solvent may be used. For example, butyl carbitol acetate (BCA), cellulose acetate (CA) or the like may be used, but the embodiments of the invention are not limited thereto.

In this instance, an amount of a metal or an amount of metal particles may be greater than an amount of the cross-linking resin in the first metal electrode layer 422. Thus, the first metal electrode layer 422 can have sufficient electrical conductivity. For example, when a sum of the amount of the metal particles and the amount of the cross-linking resin is 100 parts by weight, the metal particles may be contained in an amount of 80 to 95 parts by weight, the cross-linking resin may be contained in an amount of 5 to 20 parts by weight, and the curing agent may be included in an amount of 0.1 to 5 parts by weight. The solvent may be contained in an amount of 3 to 10 parts by weight based on 100 parts by weight of the sum of the amount of the metal particles and the amount of the cross-linking resin before the heat treatment, but the solvent is not existed due to volatilization or only a trace amount of the solvent is existed after the heat treatment. Since the amount of other materials such as the curing agent after heat treatment is not large, the weight of the metal or metal particles in the first metal electrode layer 422 may be 80 to 95 parts by weight.

If the amount of the metal particles is less than 80 parts by weight or the amount of the cross-linking resin exceeds 20 parts by weight, the electrical conductivity by the metal particles may not be sufficient. If the amount of the metal particles exceeds 95 parts by weight or the amount of the cross-linking resin is less than 5 parts by weight, the effect of preventing the penetration of the solder layer by the cross-linking resin may not be sufficient because the amount of the cross-linking resin is insufficient. The curing agent may be included in an amount such that sufficient curing can be achieved without deteriorating the properties of the low-temperature-firing paste. The solvent may be included in such an amount that uniformly mixes various materials and easily volatilized during the heat treatment so as not to deteriorate the electrical properties. However, the embodiments of the invention are not limited to these numerical values.

In the embodiment, the metal particles of one kind of particles may be used, or different metal particles having different shapes, particle sizes, materials, etc. may be mixed and used.

Hereinafter, an example of a planar shape of the first metal electrode layer 422 of the first electrode 42 will be described in detail with reference to FIGs. 1 and 2. FIG. 2 is a front plan view of the solar cell 100 shown in FIG. 1. For the simplicity, the first transparent electrode layer 420 of the first electrode 42 is not shown in FIG. 2.

Referring to FIG. 2, the first metal electrode layer 422 of the first electrode 42 may include a plurality of finger electrodes 42a spaced apart from each other with a predetermined pitch. Although the finger electrodes 42a are parallel to each other and parallel to an edge of the semiconductor substrate 10, the embodiments of the invention are not limited thereto. The first metal electrode layer 422 of the first electrode 42 may include a bus bar electrode 42b connecting the finger electrodes 42a in a direction crossing (for example, orthogonal to) the finger electrodes 42a. Only one bus bar electrode 42b may be provided or a plurality of bus bar electrodes 42b may be provided with a pitch larger than the pitch of the finger electrodes 42a as shown in FIG. 2. In this instance, a width of the bus bar electrode 42b may be larger than a width of the finger electrode 42a, but the embodiments of the invention are not limited thereto. Therefore, the width of the bus bar electrode 42b may be equal to or smaller than the width of the finger electrode 42a.

Referring to FIG. 1 again, a second tunneling layer 54 may be positioned on (e.g., be in contact with) the back surface of the semiconductor substrate 10, a second intermediate layer 54a may be positioned on (e.g., be in contact with) the second tunneling layer 54, and the second conductive region 30 may be positioned on (e.g., be in contact with) the second intermediate layer 54a. Also, the second electrode 44 electrically connected to the second conductive region 30 may be positioned on (e.g., be in contact with) the second conductive region 30. The second electrode 44 may include a second transparent electrode layer 440 and a second metal electrode layer 442 which are sequentially stacked on the second conductive region 30. Except that the second tunneling layer 54, the second intermediate layer 54a, the second conductive region 30, and the second electrode 44 are located on the back surface of the semiconductor substrate 10, the descriptions of the first tunneling layer 52, the first intermediate layer 52a, the first conductive region 20, and the second electrode 44 may be applied to them, respectively, as they are. However, the first conductive region 20 and the second conductive region 30 may be have different materials because the polarities of carriers extracted from the first conductive region 20 and the second conductive region 30 are different from each other. The first tunneling layer 52 and the second tunneling layer 54 may have the same thickness, shape, material, or the like, or may have different thicknesses, shapes, materials, and the like. The first intermediate layer 52a and the second intermediate layer 54a may have the same thickness, shape, material, or the like, and may have different thicknesses, shapes, materials, and the like. The first transparent electrode layer 420 and/or the first metal electrode layer 422 and the second transparent electrode layer 440 and/or the second metal electrode layer 442 may have the same shape and/or material, and may have different shapes and/or materials. Widths and pitches of the finger electrodes 42a and the bus bar electrode 42b of the first metal electrode layer 422 may be the same as or different from widths and pitches of the finger electrodes and bus bar electrode of the second metal electrode layer 442, respectively. Alternatively, the planar shapes of the first metal electrode layer 422 and the second metal electrode layer 442 may be different from each other, or the stacked structures of the first electrode 42 and the second electrode 44 may be different from each other. Various other variations are possible.

Although it is not shown in FIG. 1, an insulating layer such as a passivation film, an anti-reflection layer, a reflection layer, and the like may be further formed on the first and second conductive regions 20 and 30 and/or on the first and second transparent electrode layers 422 and 442.

In this instance, in the embodiment, at least one of the first and second conductive regions 20 and 30 is formed of a binary metal oxide layer having an amorphous structure. Hereinafter, it is exemplified that each of the first and second conductive regions 20 and 30 includes a binary metal oxide layer having an amorphous structure.

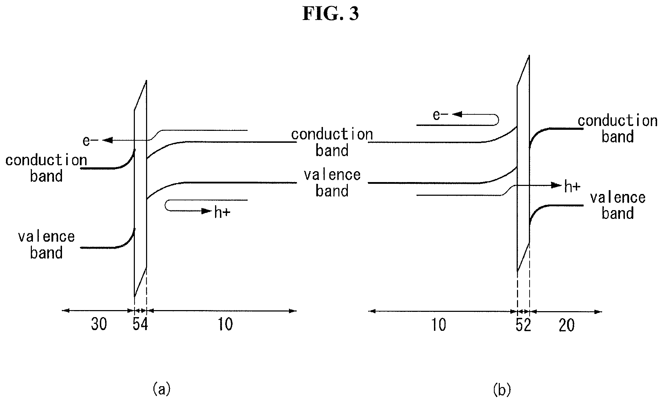

More particularly, each of the first conductive region 20 and the second conductive region 30 may include a metal compound being able to selectively extract and collect a first carrier or a second carrier (an electron or a hole) having different polarities in consideration of the energy band with respect to the semiconductor substrate 10. Accordingly, the first conductive region 20 and the second conductive region 30 do not include a semiconductor material, or a material that acts as a dopant in the semiconductor material. This will be described in more detail with reference to FIG. 3.

FIG. 3 shows a band diagram of the semiconductor substrate 10, the second tunneling layer 42, and the second conductive region 30 in the solar cell 100 according to the embodiment of the invention in (a), and a band diagram of the semiconductor substrate 10, the first tunneling layer 52, and the first conductive region 20 in the solar cell 100 according to the embodiment of the invention in (b). Here, since the first and second intermediate layers 52a and 54a are layers in which the carrier moves through the tunneling as in the first and second tunneling layers 52 and 54, the first and second intermediate layers 52a and 54a does not greatly affect the band diagram, and thus, the first and second intermediate layers 52a and 54a are not shown in FIG. 3.

Here, as described above, the semiconductor substrate 10 may be formed of the base region 110 having the n-type.

Referring to (a) and (b) FIG. 3, in the embodiment, one of the first conductive region 20 and the second conductive region 30 extracts and collects the first carriers while the other of the first conductive region 20 and the second conductive region 30 extracts and collects the second carriers having an opposite polarity to that of the first carriers.

Hereinafter, it is exemplified that the first conductive region 20 extracts holes and the second conductive region 30 extracts electrons. According to this, the first conductive region 20 acts as an emitter region by extracting holes having an opposite polarity from electrons which are the majority carriers of the base region 110 of the n-type and, and the second conductive region 30 acts as a field region (a back surface field region) by extracting electrons which are the majority carriers of the base region 110 of the n-type. According to this, the first conductive region 20, which is located on the front surface of the semiconductor substrate 10 and acts as the emitter region that substantially related to the photoelectric conversion, can effectively extract and collect the holes having a relatively low moving speed. However, the embodiments of the invention are not limited thereto. The first conductive region 20 positioned on the front surface of the semiconductor substrate 10 constitute a front electric field region for extracting electrons, and the second conductive region 30 positioned on the back surface of the semiconductor substrate 10 act as an emitter region for extracting holes.

More particularly, a binary metal compound layer constituting the first conductive region 20 capable of selectively extracting and collecting holes may have a Fermi level lower than a Fermi level of the semiconductor substrate 10, and may have a work function capable of obtaining a high open-circuit voltage and a low resistance while preventing a mismatch of the work function based on an electron affinity of 4.05 eV of the semiconductor substrate 10. For example, the work function of the first conductive region 20 may be 5.0 eV or more. If the work function is less than 5.0 eV, it may be difficult to selectively collect only holes except electrons.

When the first conductive region 20 formed of the metal compound layer having the Fermi level and the work function is bonded to the semiconductor substrate 10 while interposing the first tunneling layer 52 therebetween, the semiconductor substrate 10 and the first conductive region 20 are aligned and bonded so as to have the same Fermi level, as shown in (b) of FIG. 3. When the first conductive region 20 is bonded to the semiconductor substrate 10 as shown in (b) of FIG. 3, holes at a valence band of the semiconductor substrate 10 can be easily transferred to a valence band of the first conductive region 20 by passing through the first tunneling layer 52 (more particularly, the first tunneling layer 52 and the first intermediate layer 52a). On the other hand, electrons of the semiconductor substrate 10 do not pass through the first tunneling layer 52.

The binary metal compound layer that may be used for the first conductive region 20 may include a molybdenum oxide layer formed of a molybdenum oxide, a tungsten oxide layer formed of a tungsten oxide (e.g., WO₃), a vanadium oxide layer formed of a vanadium oxide, a nickel oxide layer formed of a nickel oxide, a rhenium oxide layer formed of a rhenium oxide, and the like. In particular, when the first conductive region 20 includes the molybdenum oxide layer or the tungsten oxide layer, the effect of selectively collecting holes may be excellent.

Also, a binary metal compound layer constituting the second conductive region 30 capable of selectively extracting and collecting electrons may have a Fermi level higher than a Fermi level of the semiconductor substrate 10, and may have a work function capable of obtaining a high open-circuit voltage and a low resistance while preventing a mismatch of the work function based on the electron affinity of 4.05 eV of the semiconductor substrate 10. For example, the work function of the second conductive region 30 may be 4.5 eV or less. If the work function is greater than 4.5 eV, it may be difficult to selectively collect only electrons.

When the second conductive region 30 formed of the metal compound layer having the Fermi level and the work function is bonded to the semiconductor substrate 10 while interposing the second tunneling layer 54 therebetween, the semiconductor substrate 10 and the second conductive region 30 are aligned and bonded so as to have the same Fermi lever, as shown in (a) of FIG. 3. When the second conductive region 30 is bonded to the semiconductor substrate 10 as shown in (a) of FIG. 3, electrons at a conduction band of the semiconductor substrate 10 can be easily transferred to a conduction band of the second conductive region 30 by passing through the second tunneling layer 54 (more particularly, the second tunneling layer 54 and the second intermediate layer 54a). On the other hand, the holes of the semiconductor substrate 10 do not pass through the second tunneling layer 54.

For example, the metal compound layer that may be used for the second conductive region 30 may include a titanium oxide layer formed of a titanium oxide (e.g., TiO₂), a zinc oxide layer formed of a zinc oxide(e.g., ZnO), and a niobium oxide layer formed of a niobium oxide (e.g., Nb₂O₅). In particular, when the second conductive region 30 includes the titanium oxide layer, the effect of selectively collecting electrons can be excellent.

The first and second conductive regions 20 and 30 having the binary metal oxide layer are formed of materials that can easily extract and collect the first or second carriers. Also, The first and second conductive regions 20 and 30 can prevent recombination, which may induced by the dopant, and thus improve an open voltage. In addition, the loss due to light absorption can be reduced as compared with a doped region or a doped film, and a short circuit current density can be improved. Thus, efficiency of the solar cell 100 can be improved. In addition, the solar cell 100 can be manufactured by omitting a dopant doping process, a dopant activating process, and the like. In particular, since a high temperature process is not required, a process can be performed at a low temperature, thereby simplifying a manufacturing process and reducing manufacturing cost. Therefore, the productivity of the solar cell 100 can be improved.

In this instance, the first and second conductive regions 20 and 30, each formed of the binary metal oxide layer, in the embodiment have an amorphous structure. If the binary metal oxide layer has a crystalline structure, the passivation property is significantly lowered and the efficiency of the solar cell 100 is greatly lowered. The exact reason for this is not known, but this was confirmed experimentally. Although it is not clear, it is expected that an optical absorption at the binary metal oxide layer is greatly increased and thus a current loss is induced, and a surface roughness of the binary metal oxide layer is increased and it acts as surface defects, thereby increasing the recombination loss, when the crystal structure is included in the binary metal oxide layer with a large amount.

For example, an interfacial portion of the first and second conductive regions 20 and 30 adjacent to the first or second tunneling layer 52 or 54 may be formed of an amorphous area AA where an amorphous portion having an amorphous structure is wider than a crystalline portion having a crystalline structure. When the first and second conductive regions 20 and 30 have the above structures, sufficient passivation properties can be achieved. Particularly, when the amorphous area AA formed at the interfacial portion of the first and second conductive regions 20 and 30 adjacent to the first or second tunneling layers 52 or 54 has an amorphous structure as a whole, superior passivation property can be achieved. For example, an area ratio of the amorphous portion at the interfacial portion of the first and second conductive regions 20 and 30 adjacent to the first or second tunneling layer 52 or 54 may be 95% to 100% (for example, 99% to 100%). Within such a range, the solar cell 100 having the first and second conductive regions 20 and 30 of the binary metal oxide layers can have excellent efficiency.

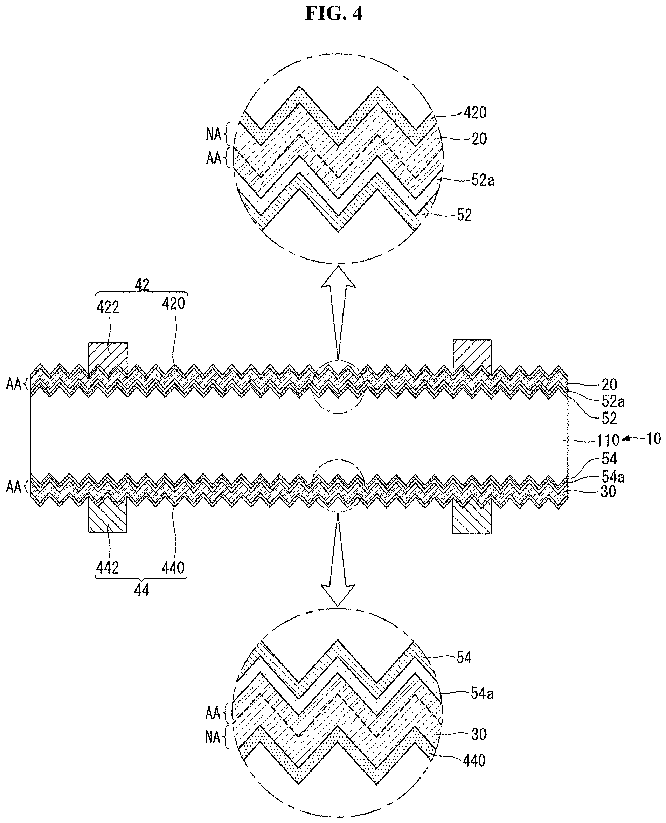

In the drawings, it is exemplified that the amorphous area AA is entirely formed in a thickness direction of the first and second conductive regions 20 and 30. However, the embodiments of the invention are not limited thereto. As another embodiment, as shown in FIG. 4, the amorphous area AA may be partially formed in the thickness direction of the first and/or the second conductive regions 20 and 30, and the amorphous area AA may be formed at a portion near the first or second intermediate layer 52a or 54a, the first or second tunneling layer 52 or 54, or the semiconductor substrate 10. In this instance, a ratio of a thickness of the amorphous area AA to a total thickness of the first or second conductive region 20 or 30 may be 0.2 or more (that is, 0.2 to 1), or the thickness of the amorphous area AA may be 1 nm or more. When the amorphous area AA having a thickness greater than a certain value (for example, the above ratio in the thicknesses of 0.2 or more or the thickness of 1 nm or more) is formed at the interfacial portion adjacent to the first or second tunneling layer 52 or 54 or the first or second intermediate layer 52a or 54a, the passivation property can be sufficiently achieved. In the drawing, it is exemplified that a non-amorphous area NA having a crystalline portion wider than the crystalline portion of the amorphous area AA is entirely formed on the amorphous area AA. However, the embodiments of the invention are not limited thereto. The non-amorphous area NA may be partially formed in a plan view. The first and/or second conductive regions 20 and/or 30 of this structure may formed when process conditions of a forming process are unstable to some degrees or when process conditions of a subsequent process are unstable to some degrees. However, the embodiments of the invention are not limited thereto, and the first and/or second conductive regions 20 and/or 30 of this structure may be formed by intentionally controlling the process conditions. Because the non-amorphous area NA may have the crystalline portion with a large area, the carrier mobility can be enhanced, and thus, the efficiency of transferring the carrier to the first or second electrode 42 or 44 can be improved.

In the above descriptions and drawings, it is exemplified that each of the first and second conductive regions 20 and 30 is made of the binary metal compound layer. However, the embodiments of the invention are not limited thereto, and only one of the first and second conductive regions 20 and 30 may be formed of the above-described binary metal compound layer. Various other variations are possible.

In the embodiment, the first intermediate layer 52a is positioned between the first tunneling layer 52 and the first conductive region 20 and the second intermediate layer 54a is positioned between the second tunneling layer 54 and the second conductive region 30. Hereinafter, the first or second tunneling layer 52 or 54 will be referred to as a tunneling layer 52 or 54, the corresponding first or second intermediate layer 52a or 54a will be referred to as an intermediate layer 52a or 54a, and the corresponding first or second conductive region 20 or 30 will be referred to as a conductive region 20 or 30.

The intermediate layer 52a or 54a is located between the tunneling layer 52 or 54 and the conductive region 20 or 30 to change the surface properties (i.e., by modifying the surface) in the embodiment so that the conductive region 20 or 30 can be stably and entirely formed while having an amorphous structure. This will be explained in more detail later. In addition, the intermediate layer 52a or 54a also prevents the material of the conductive region 20 or 30 from diffusing into the tunneling layer 52 or 54 or the semiconductor substrate 10 and from deteriorating the interface properties. More particularly, in the conductive region 20 or 30 made of the binary metal oxide layer, an oxidation number may be largely varied depending on the process conditions. In the case where the conductive region 20 or 30 does not have a stable oxidation number, a bonding between a metal and oxygen of the conductive region 20 or 30 may be easily broken and the separated metal may diffuse into the tunneling layer 52 or 54 or the semiconductor substrate 10. Then, the passivation property may be deteriorated and the leakage current may be also increased by the diffused metal, thereby largely deteriorating the electrical property. When the intermediate layer 52a or 54a is positioned between the tunneling layer 52 or 54 and the conductive region 20 or 30, the intermediate layer 52a or 54a can acts as a capping layer or a barrier buffer layer for preventing the metal included in the conductive region 20 or 30 from diffusing to the tunneling layer 52 or 54. As a result, the passivation property can be maintained to be excellent and the leakage current can be prevented to improve the electrical properties.

As described above, the tunneling layer 52 or 54 may be formed of a silicon oxide layer, an amorphous silicon layer, or the like. In this instance, the tunneling layer 52 or 54 passivates surface defects such as a dangling bond or a lattice mismatch of the semiconductor substrate 10 to enhance an open-circuit voltage. In order to further improve the passivation properties, the tunneling layer 52 or 54 may be formed under an atmosphere containing hydrogen or may be subjected to a subsequent heat treatment under an atmosphere containing hydrogen, and thus, the tunneling layer 52 or 54 includes the hydrogen. Accordingly, the tunneling layer 52 or 54 is hydrogen-terminated, the tunneling layer 52 or 54 has a hydrogenated terminal, or hydrogen is positioned at a terminal of the tunneling layer 52 or 54. In one example, the tunneling layer 52 or 54 may be a hydrogenated silicon oxide layer or a hydrogenated intrinsic amorphous silicon layer. When the tunneling layer 52 or 54 or the tunneling layer 52 or 54 is hydrogen-terminated, if the conductive region 20 or 30 formed of the binary metal oxide layer is formed directly on the tunneling layer 52 or 54, the metal may not be properly bonded to the oxide. Since the tunneling layer 52 or 54 being hydrogen-terminated is hydrophobic, a probability that a compound comprising the metal of the binary metal oxide layer (e.g., a metal precursor) is chemically bonded to the hydrogenated terminal is low. As a result, the conductive region 20 or 30 is sparsely formed in a local region and is difficult to have a uniform thickness, resulting in increasing a surface roughness. In this instance, materials of the electrode 42 or 44 may penetrate into the conductive region 20 or 30 during a subsequent heat treatment process such as a process of forming the electrode 42 or 44. In addition, since the oxidation number of the metal oxide layer constituting the conductive region 20 or 30 may be greatly affected by a temperature and adjacent layers, the properties of the conductive region 20 or 30 may be changed at a portion where the conductive region 20 or 30 is thin during the subsequent heat treatment process, and accordingly, the conductive region 20 or 30 may have not desired properties (e.g., the amorphous structure). Particularly, the poor surface passivation property with a very small area may largely affect an entire solar cell 100. Therefore, the surface passivation property of the semiconductor substrate 10 can be excellent only when the conductive region 20 or 30 is uniformly formed. Also, the conductive regions 20 or 30 having a non-uniform thickness may not be advantageous for a selective extraction of the carrier. Alternatively, in order to form the conductive region 20 or 30 having the amorphous structure uniformly and stably, the process conditions should be adjusted very strictly, which may complicate the process and increase the process cost.

In consideration of this, in the embodiment, the intermediate layer 52a or 54a having a hydroxyl group (an OH group) is formed on the tunneling layer 52 or 54. More particularly, the intermediate layer 52a or 54a is hydrophilic because the hydroxyl group is present at a terminal of the intermediate layer 52a or 54a or the intermediate layer 52a or 54a has the terminal having the hydroxyl group. A method for forming the intermediate layer 52a or 54a having the hydroxyl group at a surface side or a terminal of the intermediate layer 52a or 54a will be described in detail later in a method for manufacturing the solar cell 100.

When the conductive region 20 or 30 made of the binary metal oxide layer is formed on the hydrophilic intermediate layers 52a and 54a including the hydroxyl group, a compound (e.g., a metal precursor) including the metal of the binary metal oxide layer can be easily chemically bonded to the hydroxyl group. As a result, the conductive region 20 or 30 can have a uniform thickness while having an amorphous structure.

The intermediate layer 52a or 54a having the hydroxyl group may be an insulating layer formed of oxide or the like. For example, the intermediate layer 52a or 54a may include a silicon oxide layer, aluminum oxide, a hafnium oxide layer, or the like. This is because these materials can be easily formed by various deposition methods. For example, the intermediate layer 52a or 54a may be the silicon oxide layer, which can effectively improve the interface properties of the semiconductor substrate 10 and can be manufactured at low cost. For reference, a nitride film (e.g., a silicon nitride film) may not be suitable for the intermediate layer 52a or 54a due to its low optical properties.

The intermediate layer 52a or 54a has the hydroxyl group more than the tunneling layer 52 or 54, and the tunneling layer 52 or 54 has the hydrogen more than the intermediate layer 52a or 54a. That is, an amount of the hydroxyl group of the intermediate layer 52a or 54a is greater than an amount of the hydroxyl group of the tunneling layer 52 or 54, and an amount of the hydrogen of the tunneling layer 52 or 54 is greater than an amount of the hydrogen of the intermediate layer 52a or 54a. The intermediate layer 52a or 54a and the tunneling layer 52 or 54 may be formed of the same material or different materials. However, the intermediate layer 52a or 54a and the tunneling layer 52 or 54 differ from each other in whether the terminal is treated to have the hydroxyl group or the hydrogen, and thus, there is a difference in properties. That is, the intermediate layer 52a or 54a mainly having the hydroxyl group at the terminal thereof may be hydrophilic, and the tunneling layer 52 or 54 mainly having the hydrogen at the terminal thereof may be hydrophobic.

The presence or absence of the hydroxyl group or the hydrogen at the terminal of the intermediate layer 52a or 54a and the tunneling layer 52 or 54 may be measured by an x-ray photoelectron spectroscopy (XRD) or a Fourier transform infrared Spectroscopy (FT-IR).

The tunneling layer 52 or 54 may have an amorphous structure, and the intermediate layer 52a or 54a may have an amorphous structure or a crystalline structure. As described above, when the conductive region 20 or 30 have the amorphous structure, the solar cell 100 can operate stably.

A thickness of the intermediate layer 52a or 54a may be the same as, smaller than, or greater than a thickness of the tunneling layer 52 or 54. However, the tunneling layer 52 or 54 may have a thickness greater than a predetermined level to passivate the surface of the semiconductor substrate 10, and the intermediate layer 52a or 54a may be thin enough to change the surface properties. In one example, the thickness of the intermediate layer 52a or 54a may be the same as or smaller than the thickness of the tunneling layer 52 or 54. Particularly, when the intermediate layer 52a or 54a may be thinner than the tunneling layer 52 or 54, the processing time can be reduced and the carrier path can be minimized. For example, the thickness of the intermediate layer 52a or 54a may be 1 nm or less. According to this, the processing time can be minimized. However, the embodiments of the invention are not limited thereto, and the intermediate layer 52a or 54a may be formed to have a relatively large thickness by increasing the process time.

When light is incident on the solar cell 100 according to the embodiment, electrons and holes are generated by photoelectric conversion. One of the generated holes and electrons is tunneled through the first tunneling layer 52 and the first intermediate layer 52a, is transferred to the first conductive region 20, and then, to the first electrode 42. The other one of the generated holes and electrons is tunneled through the second tunneling layer 54 and the second intermediate layer 54a, is transferred to the second conductive region 30, and then, to the second electrode 44. The holes and electrons transferred to the first and second electrodes 42 and 44 move to an external circuit or another solar cell 100, thereby generating electrical energy.

In the embodiment, the first and second metal electrode layers 422 and 442 of the solar cell 100 have a certain pattern, and thus, the solar cell 100 has a bi-facial structure being able to receive light from the front surface and the back surface of the semiconductor substrate 10. Accordingly, the amount of light used in the solar cell 100 can be increased and the efficiency of the solar cell 100 can be enhanced. However, the embodiments of the invention are not limited thereto.

Since the first and second conductive regions 20 and 30 are formed on the semiconductor substrate 10 while interposing the tunneling layer 52 or 54 and the intermediate layer 52a or 54a therebetween, and they are separate layers from the semiconductor substrate 10. As a result, the loss due to the recombination can be minimized as compared with the case where the doped region formed by doping the semiconductor substrate 10 with the dopant is used as the conductive region. In particular, the conductive regions 20 and 30 are formed of the binary metal oxide layer that does not contain a semiconductor material and a dopant, and therefore, the open-circuit voltage and the short-circuit current density of the solar cell 100 can be enhanced and the manufacturing process of the conductive regions 20 and 30 can be simplified. Thus, efficiency and productivity of the solar cell 1 00 can be improved.

In addition, in the embodiment, the intermediate layer 52a or 54a is positioned between the tunneling layer 52 or 54 and the conductive region 20 or 30 so that the conductive region 20 or 30 can be stable and have a uniform thickness. Further, the intermediate layer 52a or 54a acts as a capping layer or a barrier buffer layer, thereby preventing the surface passivation properties from being deteriorated. Thus, efficiency and reliability of the solar cell 100 can be improved.

The solar cell 100 described above may be formed by any of various manufacturing methods. Hereinafter, a method for manufacturing a solar cell 100 according to an embodiment will be described in detail.

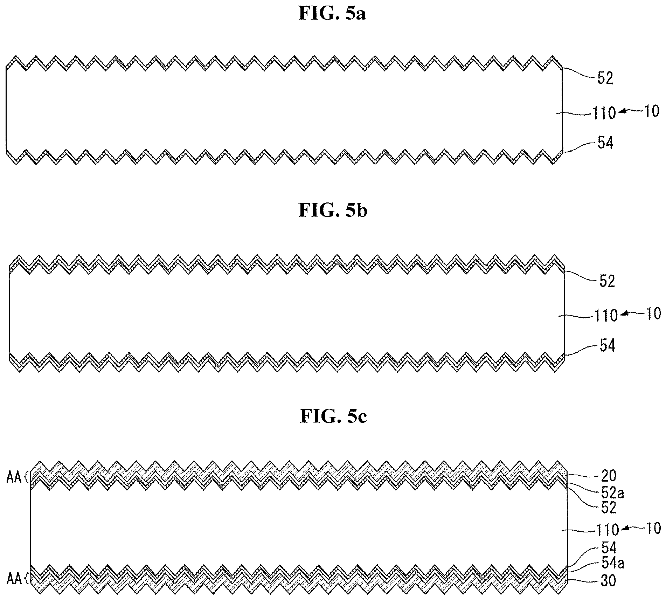

Hereinafter, a method for manufacturing a solar cell 100 according to an embodiment of the invention will be described in detail with reference to FIGs. 5a to 5d. FIGs. 5a to 5d are cross-sectional views illustrating a method for manufacturing a solar cell 100 according to an embodiment of the invention.

As shown in FIG. 5a, first and second tunneling layers 52 and 54 are formed on a front surface and a back surface of the semiconductor substrate 10, respectively. For example, the first tunneling layer 52 positioned on the front surface of the semiconductor substrate 10 and the second tunneling layer 54 positioned on the back surface of the semiconductor substrate 10 may be simultaneously formed in the same process. This can simplify the manufacturing process. However, the embodiments of the invention are not limited thereto, and the first tunneling layer 52 and the second tunneling layer 54 may be formed by different processes.

The first and second tunneling layers 52 and 54 may be formed by a thermal growth, a deposition (e.g., a chemical vapor deposition (PECVD), an atomic layer deposition (ALD)), a chemical oxidation, or the like. However, the embodiments of the invention are not limited thereto, and the first and second tunneling layers 52 and 54 may be formed by any of various methods. In one embodiment, the tunneling layers 52 and 54 may be formed under an atmosphere including hydrogen or is subjected to subsequently heat-treated under an atmosphere including hydrogen to be hydrogenated.

In this instance, the semiconductor substrate 10 having the front surface and/or the back surface textured to have an anti-reflection structure may be used for the semiconductor substrate 10. Texturing of the surface of the semiconductor substrate 10 may be performed by a wet or dry texturing. The wet texturing may be performed by immersing the semiconductor substrate 10 in a texturing solution, and has an advantage of a short process time. In the dry texturing, the surface of the semiconductor substrate 10 may be cut by using a diamond grill, a laser, or the like. According to the dry texturing, the anti-reflection structure is uniformly formed, but the processing time is long and damage to the semiconductor substrate 10 may occur. Alternatively, the semiconductor substrate 10 may be textured by reactive ion etching (RIE) or the like. As described above, the semiconductor substrate 10 may be textured in any of various methods in the invention.

As shown in FIG. 5b, a first intermediate layer 52a is formed on the first tunneling layer 52 and a second intermediate layer 54a is formed on the second tunneling layer 54. The first intermediate layer 52a and the second intermediate layer 54a may include the same material or may include different materials. When the first intermediate layer 52a and the second intermediate layer 54a include the same material, the first and second intermediate layers 52a and 54a may be formed on both sides of the semiconductor substrate 10 simultaneously to simplify the process.

In this instance, the first and/or second intermediate layers 52a and 54a having a hydroxy group may be formed by any of various methods.

As an example, the intermediate layer 52a or 54a made of a metal oxide layer may be formed by a wet chemical oxidation. For example, the wet chemical oxidation may be performed at a temperature from room temperature to 100°C using an acidic solution (for example, a mixed solution of hydrogen peroxide and a hydrochloric acid). Since the intermediate layer 52a or 54a includes an oxide, a hydroxyl group may be positioned at a terminal of the intermediate layer 52a or 54a.

As another example, the intermediate layer 52a or 54a made of a metal oxide layer may be formed by an oxidation process in which the tunneling layer 52 or 54 is formed and then heat-treated in a state where ozone (O₃) or water (H₂O) is supplied. According to this, oxygen atoms are bonded to the hydrogen located at a terminal of the tunneling layer 52 or 54 to form a SiO-H bond, thereby forming the intermediate layer 52a or 54a having the hydroxyl group. At least a part of the tunneling layer 52 or 54 (particularly, a portion adjacent to the surface of the tunneling layer 52 or 54) may be converted into the intermediate layer 52a or 54a. As an example, a temperature of this heat treatment process is not so high so that the tunneling layer 52 or 54 adjacent to the semiconductor substrate 10 remains and only the portion adjacent to the surface of the tunneling layer 52 or 54 and remote from the semiconductor substrate 10 is converted to the intermediate layer 52a or 54a. As an example, this process may be performed in an apparatus (e.g., a deposition apparatus) that forms the conductive region 20 or 30. Then, the first and/or second intermediate layer 52a or 54a, and the first and/or second conductive region 20 or 30 may be formed by an in-situ process that is continuously performed in the same apparatus. Accordingly, the process can be simplified.

As yet another embodiment, the first and/or second intermediate layer 52a and/or 54a may be formed by an atomic layer deposition (ALD), a plasma enhanced chemical vapor deposition (PECVD), a physical vapor deposition (PVD), or the like. In this instance, a hydroxyl group may be located at a terminal of the intermediate layer 52a or 54a by forming the intermediate layer 52a or 54a including an oxide. In addition, it is possible to supply ozone (O₃) or water (H₂O) during the deposition process, but the process of supplying the ozone or the water may not be separately performed for simplifying the process. As an example, this process may be performed in an apparatus (e.g., a deposition apparatus) that forms the conductive region 20 or 30. Then, the first and/or second intermediate layer 52a and/or 54a and the first and/or second conductive region 20 and/or 30 may be formed by the in-situ process, thereby simplifying the process.

In this instance, the process temperature of the above-described heat-treatment process or deposition process may be 150 °C to 250 °C. In this temperature range, the intermediate layer 52a or 54a having the hydroxyl group can be stably formed. The temperature range may be considered in the case where the tunneling layer 52 or 54 is an amorphous silicon layer. However, the embodiments of the invention are not limited thereto, and the process temperature may be changed in consideration of the materials of the tunneling layer 52 or 54, and the like.

Next, as shown in FIG. 5c, a first conductive region 20 is formed on the first intermediate layer 52a and a second conductive region 30 is formed on the second intermediate layer 54a. In the embodiment, each of the first conductive region 20 and the second conductive region 30 (hereinafter, referred to as the conductive regions 20 and 30) formed of the binary metal oxide layer has an amorphous structure. Particularly, in the embodiment, at least an interfacial portion of the conductive regions 20 and 30 adjacent to the first tunneling layer 52 or the second tunneling layer 54 (hereinafter, referred to as the tunneling layer 52 or 54) includes an amorphous area AA. Since a phase change of the binary metal oxide layer may be easily induced depending on the process conditions and the electrical and optical properties of the binary metal oxide layer may be greatly changed by the phase of the metal oxide layer, the conductive regions 20 and 30 must be formed by a specific manufacturing process. This will be described in detail below.

In the embodiment, the conductive regions 20 and 30 may be formed by any suitable process such as an atomic layer deposition (ALD), a physical vapor deposition (PVD), an e-beam evaporation, sputtering, or a chemical vapor deposition (CVD).

For example, in the atomic layer deposition process, by repeatedly injecting a first raw material including oxygen and a second raw material including a metal and purging the first raw material or the second raw material therebetween, the deposition of each layers of the conductive regions 20 and 30 is performed. An oxygen gas, ozone, water, or the like may be used as the first raw material, and a metal compound including a metal may be used as the second raw material. Since the atomic layer deposition process is performed on a layer-by-layer basis, a crystal structure of the conductive regions 20 and 30 can be easily controlled by adjusting a process temperature, and thus, a desired amorphous structure (particularly, an amorphous area (AA)) can easily be formed. As the physical vapor deposition, sputtering or evaporation may be used. Particularly, the evaporation may be performed at a room temperature, and therefore, the conductive regions 20 and 30 having an amorphous structure can be easily formed at a room temperature.

In particular, by using the atomic layer deposition process, thin and uniform conductive regions 20 and 30 can be formed on the semiconductor substrate 10 having an anti-reflection structure, and the mass productivity is also excellent.

More particularly, if the process temperature of the atomic layer deposition process or the physical vapor deposition process is high, the binary metal oxide is bonded to the tunneling layer 52 or 54, the intermediate layer 52a or 54a, or other layer formed before the conductivity regions 20 and 30 by a sufficient energy, and thus, the conductivity regions 20 and 30 may be have a crystalline structure. On the other hand, when the process temperature is low, the conductivity regions 20 and 30 may have an amorphous structure.

The process temperature of the atomic layer deposition process may be 250°C or less. When the process temperature of the atomic layer deposition process is 250°C or less, the conductive regions 20 and 30 may include the amorphous area AA where an amorphous portion is widely formed (e.g., the amorphous portion is entirely formed) at an interfacial portion adjacent to the tunneling layer 52 or 54. The process temperature of the atomic layer deposition process may be 100°C or more(e.g., 150°C or more). If the process temperature is less than 100°C, the conductive regions 20 and 30 may be porous, which may degrade the properties of extracting and delivering a desired carrier. Alternatively, the process temperature of the physical vapor deposition process may be from a room temperature to 250°C (e.g., 5 to 250 °C, for example, 5 to 150°C). This is because the conductive regions 20 and 30 are formed stably at this temperature to have the amorphous area AA.

In this instance, the process temperature may be slightly changed depending on materials constituting the conductive regions 20 and 30 within the above-mentioned process temperature range. This is because a process margin may vary depending on a material of an oxide.

Also, if thicknesses of the conductive regions 20 and 30 exceed a certain level, a crystal structure may be changed or a defect density may be increased gradually or during a subsequent heat-treatment process, and thus, the passivation property may be deteriorated, even if the deposition is performed by the atomic layer deposition process at the low process temperature. Accordingly, thicknesses of the conductive regions 20 and 30 formed by the atomic layer deposition process may be 30 nm or less. Accordingly, a number of cycles can be reduced and thus a process time can be reduced, and the conductive regions 20 and 30 having a desired phase can be stably formed. These thicknesses may vary depending on materials of the oxide layer constituting the conductive regions 20 and 30, for example, the thicknesses of the conductive regions 20 and 30 may be 15 nm or less. Alternatively, when the second conductive region 30 is formed of a molybdenum oxide layer having lots of defects, the second conductive region 30 may have a thickness the same as or smaller than (particularly, smaller than) that of the first conductive region 20 formed of another oxide layer .

For example, the thicknesses of the conductive regions 20 and 30 may be 2 nm or more (for example, 5 nm or more). In the embodiment, since the thicknesses of the conductive regions 20 and 30 may be uniform by the intermediate layer 52a or 54a, a desired effect can be obtained even if the thicknesses of the conductive regions 20 and 30 is about 2 nm. If the thicknesses of the conductive regions 20 and 30 are less than 2 nm (particularly, less than 5 nm), the properties of the conductive regions 20 and 30 may be changed due to a first or second transparent electrode layer 420 or 440 located on the conductive regions 20 and 30, and thus, the surface recombination properties may be deteriorated. In addition, one of the conductive regions 20 and 30 for extracting electrons (for example, the second conductive region 30) may sufficiently extract and deliver the electrons only when it has a thickness of a certain thickness or more. Because the passivation effect by a surface field region is insufficient when the one of the conductive regions 20 and 30 for extracting the electrons is bonded to the semiconductor substrate 10 of the n-type, the one of the conductive regions 20 and 30 for extracting the electrons is difficult to sufficiently extract the electrons if its thickness is thin. However, the embodiments of the invention are not limited thereto.

In the embodiment, the second conductive region 30 may be formed after the first conductive region 20 is formed, or the first conductive region 20 may be formed after the second conductive region 30 is formed.

For example, when a first process temperature for forming the first conductive region 20 and a second process temperature for forming the second conductive region 30 are different from each other, one of the first and second conductive regions 20 and 30, which is formed at a relatively high process temperature, is firstly formed and then, the other of the first and second conductive regions 20 and 30, which is formed at a relatively low process temperature, is formed. That is, if the first process temperature is higher than the second process temperature, the second conductive region 30 is formed after forming the first conductive region 20. If the second process temperature is higher than the first process temperature, the first conductive region 20 is formed after forming the second conductive region 30. If the process at the relatively low temperature is firstly performed and then the process at the relatively high temperature is performed, properties of a material formed by the process at the relatively low temperature may be deteriorated or the material formed by the process at the relatively low temperature may be crystallized during the process at the relatively high temperature. Thus, the embodiment is for preventing them. For example, when the first conductive region 20 is formed of a molybdenum oxide layer and the second conductive region 30 is formed of a titanium oxide layer, the second conductive region 30 is firstly formed, and then, the first conductive region 20 is formed. This is because the process margin for the process temperature is slightly smaller in the molybdenum oxide layer than in the titanium oxide layer so that the molybdenum oxide layer may have a lower process temperature. However, the embodiments of the invention are not limited thereto.

In the above descriptions and the drawings, it is exemplified that the first and second tunneling layers 52 and 54 are formed, and the first and second intermediate layers 52a and 54a are formed, and then, the first and second conductive regions 20 and 30 are formed. However, the embodiments of the invention are not limited thereto. The first tunneling layer 52, the first intermediate layer 52a, the first conductive region 20, the second tunneling layer 54, the second intermediate layer 54a, and the second conductive region 30 may be sequentially formed, or the second tunneling layer 54, the second intermediate layer 54a, the second conductive region 30, the first tunneling layer 52, the first intermediate layer 52a, and the first conductive region 20 may be sequentially formed.

Also, it is exemplified that each of the first and second conductive regions 20 and 30 is formed of the binary metal oxide layer in the above description and the drawings, any one of the first and second conductive regions 20 and 30 may be a doped region formed on the substrate 10 or a semiconductor layer separately formed on the semiconductor substrate 10. In this instance, the tunneling layer 52 or 54 corresponding to the conductive region 20 or 30 not formed of the binary metal oxide layer may be provided or may not be provided. In this instance, the doped region may be formed at the semiconductor substrate 10 by a doping process such as an ion implantation, a thermal diffusion, or laser doping. The semiconductor layer may be formed by a method such as a deposition. The doping of the semiconductor layer may be performed together with the deposition of the semiconductor layer or may be performed by a separate doping process after the deposition of the semiconductor layer. Various other methods may also be used.

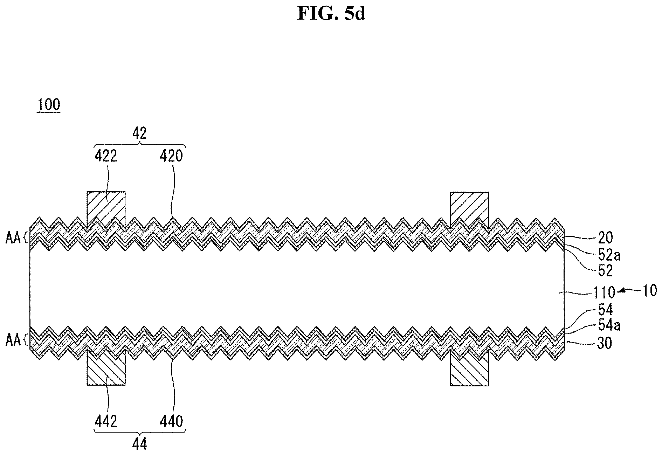

Next, as shown in FIG. 5d, a first electrode 42 electrically connected to the first conductive region 20 and a second electrode 44 electrically connected to the second conductive region 30 are formed.

For example, a first transparent electrode layer 420 and a second transparent electrode layer 440 may be formed by, for example, a vapor deposition method (for example, chemical vapor deposition (PECVD) method), a coating method, or the like. In this instance, the first transparent electrode layer 420 and the second transparent electrode layer 440 may be formed simultaneously to simplify the manufacturing process. However, the embodiments of the invention are not limited thereto, and the first and second transparent electrode layers 420 and 440 may be formed by any of various methods.

A first metal electrode layer 422 and a second metal electrode layer 442 may be formed by plating, printing, or the like. For example, the first metal electrode layer 422 and the second metal electrode layer 442 may be formed by printing a low-temperature firing paste and then drying or firing the same. The low-temperature firing paste was described in detail in the above descriptions of the first metal electrode layer 422, and thus, the detailed descriptions thereof will be omitted. In this instance, the first metal electrode layer 422 and the second metal electrode layer 442 may be formed by the same process, thereby simplifying the manufacturing process. However, the embodiments of the invention are not limited thereto, and the first and second metal electrode layers 422 and 442 may be formed by any of various methods.

Accordingly, in the embodiment, the step of forming the first and/or second electrodes 42 and 44 may be performed at a process temperature of 350°C or less (for example, 300°C or less, for example, 250°C or less). Also, all steps performed after the step of forming the conductive regions 20 and 30 may be performed at a process temperature of 350°C or less (for example, 300°C or less, for example, 250°C or less). By the temperature, the amorphous structure or the amorphous area AA of the conductive regions 20 and 30 can be maintained in a final structure without being crystallized.

According to this embodiment, the conductive region 20 or 30 formed of the binary metal oxide layer having the amorphous structure can be formed by a simple process. Thus, the solar cell 100 having excellent properties and efficiency can be formed by a simple process.

Hereinafter, a solar cell according to another embodiment of the invention will be described in detail. Detailed descriptions will be omitted for the same or extremely similar parts as those described above, and only different parts will be described in detail. It is also within the scope of the invention to combine the above-described embodiments or variations thereof with the following embodiments or modifications thereof.

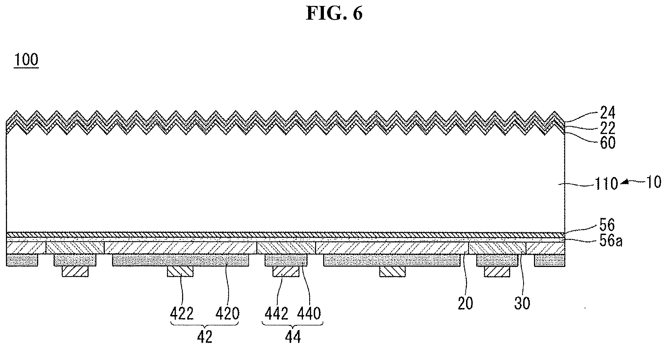

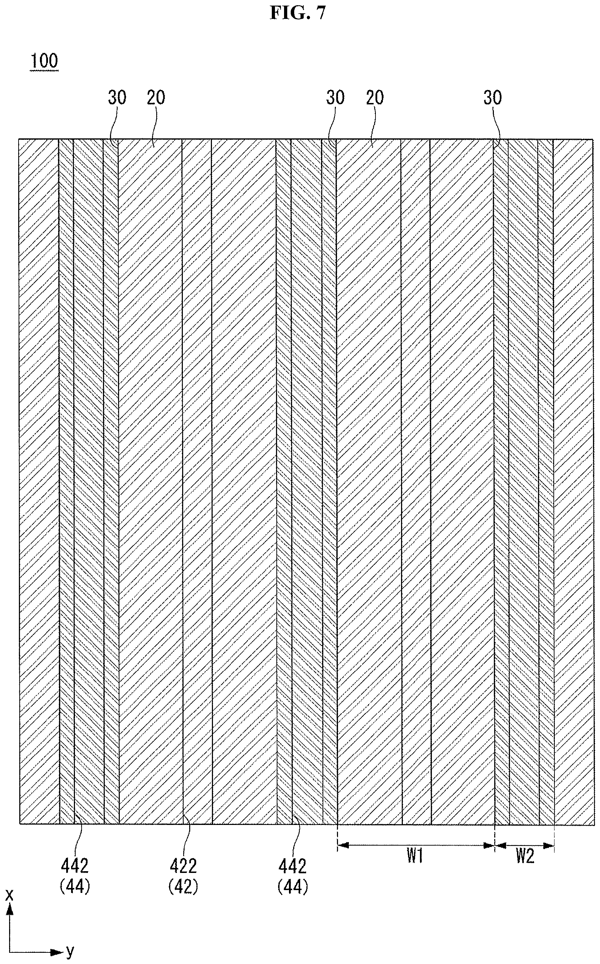

FIG. 6 is a cross-sectional view of a solar cell according to another embodiment of the invention, and FIG. 7 is a rear plan view of the solar cell shown in FIG.6. A first transparent electrode layer 420 of a first electrode 42 and a second transparent electrode layer 440 of a second electrode 44 are not shown in FIG. 7 for simplicity.

Referring to FIGs. 6 and 7, in the embodiment, a tunneling layer 56 and an intermediate layer 56a may be disposed on a back surface of a semiconductor substrate 10, and first and second conductive regions 20 and 30 may be disposed on the intermediate layer 56a to be coplanar. A front-surface-field generating layer (or a front surface field region) 60 may be entirely disposed on a front surface of the semiconductor substrate 10, and a transparent conductive layer 22 and an anti-reflection layer 24 may be disposed on the semiconductor substrate 10 or the front-surface-field generating layer 60.

As for the tunneling layer 56, the descriptions of the first or second tunneling layer 52 or 54 of the above-described embodiment may be applied as they are. As for the intermediate layer 56a, the descriptions of the first or second intermediate layer 52a or 54a of the above-described embodiment may be applied as they are. The descriptions of the first and second conductive regions 20 and 30 of the above-described embodiment may be applied to the first and second conductive regions 20 and 30, except for positions and shapes of the first and second conductive regions 20 and 30. The positions and the shapes of the first and second conductive regions 20 and 30 will be described later in more detail with reference to FIG. 7.

In this instance, an anti-reflection structure may be formed on the front surface of the semiconductor substrate 10, and a back surface of the semiconductor substrate 10 may be a mirror-polished surface. This is because properties of the tunneling layer 56 may greatly affect carrier mobility and the like.

In the embodiment, the first and second conductive regions 20 and 30 may be disposed on (for example, be in contact with) the tunneling layer 56, and side surfaces of the first and the second conductive regions 20 and 30 may be in contact with each other. Since the first conductive region 20 and the second conductive region 30 do not include a semiconductor material and a dopant, there is no problem such as a short circuit even if the side surfaces of the first and the second conductive regions 20 and 30 are in contact with each other. However, the embodiments of the invention are not limited thereto. Thus, as a modified embodiment, a barrier region may be located between the first and second conductive regions 20 and 30 on the tunneling layer 20 to prevent them from be in contact with each other. The barrier region may be formed of an empty space, or may be formed of an intrinsic semiconductor layer, a compound such as an oxide, or the like.

The front-surface-field generating layer 60 disposed on (for example, in contact with) the front surface of the semiconductor substrate 10 may be a layer having a fixed charge or a binary metal oxide layer capable of selectively collecting electrons or holes as described above. For example, the front-surface-field generating layer 60 may be an aluminum oxide layer comprising an aluminum oxide with a fixed charge. Alternatively, the front-surface-field generating layer 60 may include a molybdenum oxide layer, a tungsten oxide layer, a vanadium oxide layer, a nickel oxide layer, a rhenium oxide layer, a titanium oxide layer, a zinc oxide layer, a niobium oxide layer, or the like. Alternatively, the front-surface-field generating layer 60 may be a layer including a plurality of the above-described layers. The front-surface-field generating layer 60 may be formed of an oxide layer to effectively passivate an entire surface of the semiconductor substrate 10.

In this instance, the front-surface-field generating layer 60 may be formed of the same layer as one of the metal compound layers constituting the first and second conductive regions 20 and 30, thereby simplifying the manufacturing process. For example, each of the front-surface-field generating layer 60 and the second conductive region 30 may be formed of a titanium oxide layer.

The front-surface-field generating layer 60 may exhibit the effect of a field region for preventing a recombination in a vicinity of the front surface of the semiconductor substrate 10 by selectively collect electrons or holes or by having fixed charges in a state where it is not connected to electrodes 42 and 44 connected to other solar cell 100 or an external circuit. In this instance, the semiconductor substrate 10 does not have a separate doped region and consists only of a base region 110 so that defects of the semiconductor substrate 10 can be minimized.

In this instance, a thickness of the front-surface-field generating layer 60 may be the same as or less than a thickness of the first or second conductive region 20 or 30. Because the front-surface-field generating layer 60 is not a layer for transferring a carrier to the outside, it may have a relatively small thickness. For example, the thickness of the front-surface-field generating layer 60 may be 1 nm to 10 nm. Within the thickness range, the effect of the front-surface-field generating layer 60 can be sufficiently realized. However, the embodiments of the invention are not limited to the thickness of the front-surface-field generating layer 60.

The transparent conductive layer 22 may be positioned on (e.g., be in contact with) the front surface of the semiconductor substrate 10 or the front-surface-field generating layer 60. The transparent conductive layer 22 is a floating electrode that is not connected to an external circuit or other solar cell 100. The floating electrode can prevent unnecessary ions and the like from gathering on the surface of the semiconductor substrate 10. Accordingly, it is possible to prevent a deterioration phenomenon (for example, a potential induced degradation (PID)) of a solar cell module in a high temperature and high humidity environment. The transparent conductive layer 22 is not essential, and thus, the transparent conductive layer 22 may not be provided.

For example, the transparent conductive layer 22 may include indium tin oxide (ITO), carbon nano tube (CNT), or the like. However, the embodiments of the invention are not limited thereto, and the transparent conductive layer 22 may include any of other various materials.

The anti-reflection layer 24 may be positioned on (e.g., be in contact with) the front surface of the semiconductor substrate 10 or the transparent conductive layer 22. The anti-reflection layer 24 reduces reflectance of light incident on the front surface of the semiconductor substrate 10. Thus, the amount of light reaching the solar cell 100 can be increased. Accordingly, short-circuit current of the solar cell 100 can be increased.

The anti-reflection layer 24 may be formed of any of various materials. For example, the anti-reflection layer 24 may be a single layer selected from the group consisting of a silicon nitride layer, a silicon nitride layer having hydrogen, a silicon oxide layer, a silicon oxynitride layer, an aluminum oxide layer, a silicon carbide layer, MgF₂, ZnS, TiO₂ and CeO₂, and may have a multi-layered structure in which two or more layers of the above are combined. As one example, the anti-reflection layer 24 may be a silicon nitride layer.

The front-surface-field generating layer 60, the transparent conductive layer 22, and the anti-reflection layer 24 may be formed entirely on the front surface of the semiconductor substrate 10. Thus, the manufacturing process can be simplified and the effect of each layer can be sufficiently achieved.

In another modified embodiment, a doped region formed by doping a dopant having a conductive type the same as the base region 110 to the front surface of the semiconductor substrate 10 at a high concentration may be used as a front surface field region, without the front-surface-field generating region. In this instance, a passivation layer and/or the anti-reflection layer 24 may be disposed on the doped region.

Referring to FIG. 7, in the embodiment, the first conductive regions 20 and the second conductive regions 30 are alternately arranged in a direction crossing a longitudinal direction of the first or second conductive region 20 or 30, and each of the first conductive regions 20 and the second conductive regions 30 may have a stripe shape. Although it is not shown in the drawing, a plurality of first conductive regions 20 spaced apart from each other may be connected to each other at one edge, and a plurality of second conductive regions 30 spaced from each other may be connected to each other at the other edge. However, the embodiments of the invention are not limited thereto.

In this instance, an area of the first conductive regions 20 for collecting carriers (i.e., holes) different from the majority carriers of the base region 110 may be greater than an area of the second conductive regions 30 for collects carriers (i.e. electrons) the same as the majority carriers of the base region 110. Thus, the first conductive region 20 acting as the emitter region can be formed in a sufficient area. By the first conductive region 20 with a large area, holes having a relatively slow moving speed can be effectively collected. As one example, the areas of the first conductive regions 20 and the second conductive regions 30 may be adjusted by varying their widths. That is, a width W1 of the first conductive region 20 may be larger than a width W2 of the second conductive region 30.

First metal electrode layers 422 of the first electrode 42 may have a stripe shape corresponding to the first conductive regions 20 and second metal electrode layers 442 of the second electrode 44 may have a stripe shape corresponding to the second conductive regions 30. Although it is not shown in the drawings for simplicity, the first transparent electrode layers 420 of the first electrode 42 have a stripe shape, each having a larger area than that of the first metal electrode layer 422, and the second transparent electrode layer 420 of the second electrode 44 have a stripe shape, each having a larger area than that of the second metal electrode layer 442. Although it is not shown in the drawings, the first electrodes 42 may be connected to each other at one edge, and the second electrodes 44 may be connected to each other at the other edge. However, the embodiments of the invention are not limited thereto.

In the embodiment, the first transparent electrode layer 420 and the second transparent electrode layer 440 are not essential and the first transparent electrode layer 420 and the second transparent electrode layer 440 may not be formed. In this instance, the first metal electrode layer 422 and the second metal electrode layer 442 may be in contact with the first and second conductive regions 20 and 30, respectively. In this instance, the structure can be simplified.

In the solar cell 100 according to the embodiment, the first and second electrodes 42 and 44 (particularly, the first and second metal electrode layers 422 and 442) are all positioned on the back surface of the semiconductor substrate 10 so that there is no part for blocking the light at the front surface of the semiconductor substrate 10, thereby minimizing the light loss. Particularly, in the embodiment, at least one of the first and second conductive regions 20 and 30 is formed of a metal compound layer, and thus, the first and second metal electrode layers 422 and 442 of the first electrode 42 and the second electrode 44 may be widely formed. In this instance, by using the back-contact structure, the problem caused by the shading loss can be prevented.

The solar cell 100 may be formed by forming the tunneling layer 56 on the back surface of the semiconductor substrate 10 as stated in the descriptions with reference to FIG. 5a, forming the intermediate layer 56a thereon as stated in the descriptions with reference to FIG. 5b, forming the first and second conductive regions 20 and 30 thereon as stated in the descriptions with reference to FIG. 5c, and forming the first and second electrodes 42 and 44 formed thereon as stated in the descriptions with reference to FIG. 5d. In order to form the first and second conductive regions 20 and 30, the first and second transparent electrode layers 420 and 440, and/or the first and second metal electrode layers 422 and 442 having predetermined patterns, a mask or a mask layer may be used.

Hereinafter, the invention will be described in more detail with reference to experimental examples of the invention. However, experimental examples of the invention are provided only for exemplifying the invention and the embodiments of the invention are not limited thereto.

### Embodiment 1

First and second tunneling layers formed of an amorphous silicon were formed on front and back surfaces of an n-type single-crystalline silicon substrate. A first intermediate layer formed of a silicon oxide layer having a hydroxyl group was formed on the first tunneling layer, and a second intermediate layer formed of a silicon oxide layer having a hydroxyl group was formed on the second tunneling layer. A first conductive region formed of a molybdenum oxide layer and a second conductive region formed of a titanium oxide layer were formed. The first and second intermediate layers were formed by an atomic layer deposition process and had a thickness of 0.5 mm. The first conductive region was formed by an atomic layer deposition process at a process temperature of 200°C and had a thickness of 10 nm, and the second conductive region was formed by an atomic layer deposition process at a process temperature of 200°C and had a thickness of 10 nm. In this instance, the first and second intermediate layers, and the first and second conductive regions were continuously formed by an in-situ process in the atomic layer deposition equipment. Then, a transparent electrode layer and a metal electrode layer were sequentially formed to form first and second electrodes.

### Comparative Example 1

A solar cell was manufactured in the same manner as in Example 1 except that the first and second intermediate layers were not formed.

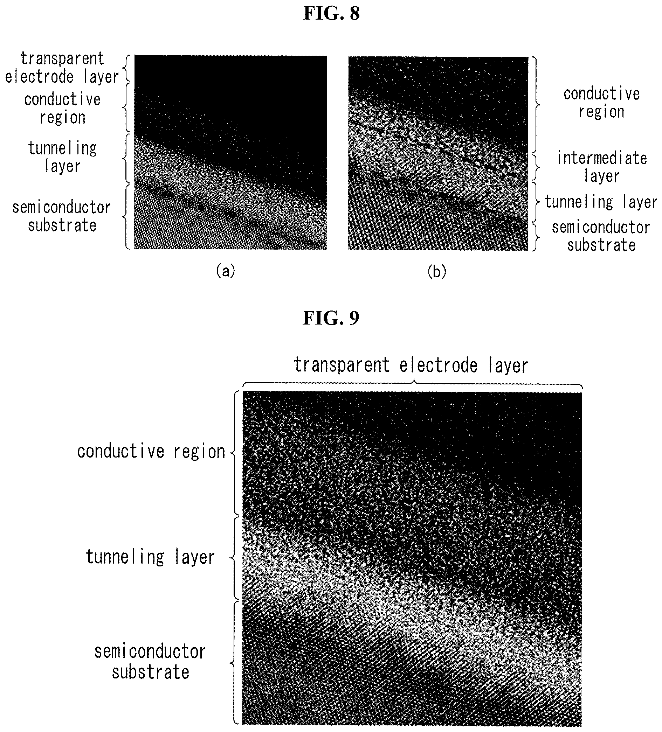

Transmission electron microscope (TEM) photographs of the solar cell according to Embodiment 1 and Comparative Example 1 were taken and shown in FIGs. 8 and 9, respectively, (a) of FIG. 8 is a photograph and (b) of FIG. 8 is a partial enlargement of the photograph to show an interface between the tunneling layer and the intermediate layer.

Referring to FIG. 8, in the solar cell according to Embodiment 1, it can be seen that the conductive region is formed to have a uniform thickness. On the other hand, referring to FIG. 9, in the solar cell according to Comparative Example 1, it can be seen that the conductive region has a non-uniform thickness and a high surface roughness. From this, it can be seen that the conductive region can be formed to have a uniform thickness when the conductive region formed of a binary metal oxide layer is formed after forming the intermediate layer on the tunneling layer, as in Embodiment 1.

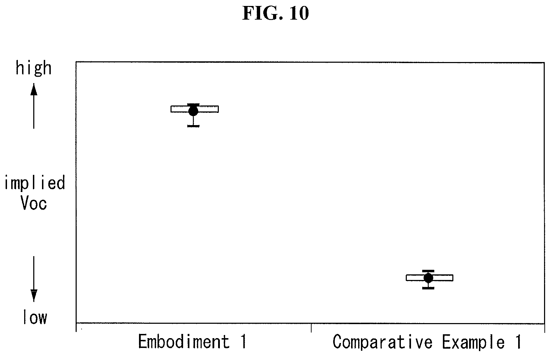

Implied open-circuit voltages (implied Voc) of the solar cell according to Embodiment 1 and Comparative Example 1 were measured, and the results are shown in FIG. 10.

Referring to FIG. 10, it can be seen that the implied open-circuit voltage is high in Embodiment 1, while the implied open-circuit voltage is relatively low in Comparative Example 1. This is expected because the intermediate layer acts as a capping layer and the conductive region is formed to have a uniform thickness by the intermediate layer in Embodiment 1.

## Claims

1. A solar cell (100) comprising:
a semiconductor substrate (10);
a tunneling layer (52, 54) on a surface of the semiconductor substrate (10);
an intermediate layer (52a, 54a) on the tunneling layer;
a first conductive region (20) on the intermediate layer (52a, 54a), wherein the first conductive region (20) including a metal oxide layer configured to extract a first carrier; and
a first electrode (42) that is electrically connected to the first conductive region,
**characterized in that** the intermediate layer (52a, 54a) includes a hydroxyl group (an OH group).

2. The solar cell of claim 1, wherein at least one of the following is fulfilled:
the intermediate layer (52a, 54a) includes a first amount of the hydroxyl group, the tunneling layer (52, 54) includes a second amount of the hydroxyl group, and the first amount is larger than the second amount; and
the tunneling layer (52, 54) is hydrogen-terminated.

3. The solar cell of any one of the preceding claims, wherein the intermediate layer (52a, 54a) includes:
an insulating layer that includes an oxide comprising the hydroxyl group.

4. The solar cell of claim 3, wherein the intermediate layer (52a, 54a) includes at least one of a silicon oxide layer, an aluminum oxide layer, and a hafnium oxide layer.

5. The solar cell of any one of the preceding claims, wherein at least one of the following is fulfilled for the intermediate layer (52a, 54a):
a thickness of the intermediate layer (52a, 54a) is equal to or thinner than a thickness of the tunneling layer (52, 54); and
a thickness of the intermediate layer (52a, 54a) is equal to or less than 1 nm.

6. The solar cell of any one of the preceding claims, wherein the metal oxide layer of the first conductive region (20) includes a binary metal oxide, or
wherein the tunneling layer (52, 54) includes a hydrogenated silicon oxide layer or a hydrogenated intrinsic amorphous silicon layer.

7. The solar cell of any one of the preceding claims, wherein the tunneling layer (52, 54) is hydrophobic and the intermediate layer (52a, 54a) is hydrophilic.

8. The solar cell of any one of the preceding claims, further comprising:
a second conductive region (30) to extract a second carrier, wherein a polarity of the first carrier is different from a polarity of the second carrier; and
a second electrode (44) that is electrically connected to the second conductive region (30),
wherein the second conductive region (30) includes a metal oxide layer comprising an amorphous structure.

9. The solar cell of claim 8, wherein the first conductive region (20) and the second conductive region (30) are coplanar on the tunneling layer (52, 54); or
wherein the solar cell further comprises another tunneling layer on the other surface of the semiconductor substrate (10) and another intermediate layer on the another tunneling layer, wherein the another intermediate layer includes a hydroxyl group, wherein the second conductive region (30) and the second electrode (44) being disposed on the another intermediate layer.

10. A method for manufacturing a solar cell, comprising:
forming a tunneling layer (52, 54) on a surface of a semiconductor substrate (10);
forming an intermediate layer (52a, 54a) on the tunneling layer (52, 54);
forming a first conductive region (20) that includes a metal oxide layer configured to extract a first carrier on the intermediate layer (52a, 54a); and
forming a first electrode (42) that is electrically connected to the first conductive region (20), **characterized in that** the intermediate layer (52a, 54a) includes a hydroxyl group (an OH group).

11. The method of claim 10, wherein forming the intermediate layer
(52a, 54a) comprises forming the intermediate layer using a wet chemical oxidation process;
wherein forming the intermediate layer (52a, 54a) on the tunneling layer
(52, 54) includes, after forming the tunneling layer (52, 54) on the surface of the semiconductor substrate (10), converting at least a part of the tunneling layer
(52, 54) to the intermediate layer (52a, 54a) using an oxidation process in which a heat treatment is performed in a state that ozone or water is supplied; or
wherein forming the intermediate layer (52a, 54a) comprises forming the intermediate layer (52a, 54a) on the tunneling layer (52, 54) using a deposition process after forming the tunneling layer (52, 54) on the surface of the semiconductor substrate (10).

12. The method of claim 10 or 11, wherein forming the tunneling layer
(52, 54) comprises forming the tunneling layer (52, 54) in atmosphere including hydrogen, or
wherein the tunneling layer (52, 54) is hydrogenated by a subsequent heat treatment in atmosphere including hydrogen.

13. The method of any one of claims 10 to 12, wherein the intermediate layer (52a, 54a) includes:
an insulating layer that includes an oxide comprising a hydroxyl group.

14. The method of claim 13, wherein the intermediate layer (52a, 54a) includes at least one of a silicon oxide layer, an aluminum oxide layer, or a hafnium oxide layer.

15. The method of any one of claims 10 to 14, wherein the metal oxide layer of the first conductive region (20) includes a binary metal oxide, or
wherein the tunneling layer (52, 54) includes a hydrogenated silicon oxide layer or a hydrogenated intrinsic amorphous silicon layer.

## Patentansprüche

1. Solarzelle (100) umfassend:
ein Halbleitersubstrat (10);
eine Tunnelschicht (52, 54) auf einer Oberfläche des Halbleitersubstrats (10);
eine Zwischenschicht (52a, 54a) auf der Tunnelschicht;
einen ersten leitfähigen Bereich (20) auf der Zwischenschicht (52a, 54a), wobei der erste leitfähige Bereich (20) eine Metalloxidschicht umfasst, die zum Extrahieren eines ersten Trägers eingerichtet ist; und
eine erste Elektrode (42), die elektrisch mit dem ersten leitfähigen Bereich verbunden ist,
**dadurch gekennzeichnet, dass** die Zwischenschicht (52a, 54a) eine Hydroxygruppe (eine OH-Gruppe) enthält.

2. Solarzelle nach Anspruch 1, wobei mindestens eines der folgenden erfüllt ist:
die Zwischenschicht (52a, 54a) enthält eine erste Menge der Hydroxygruppe, die Tunnelschicht (52, 54) enthält eine zweite Menge der Hydroxygruppe und die erste Menge ist größer als die zweite Menge; und
die Tunnelschicht (52, 54) ist wasserstoffterminiert.

3. Solarzelle nach einem der vorhergehenden Ansprüche, wobei die Zwischenschicht (52a, 54a) umfasst:
eine Isolierschicht, die ein die Hydroxygruppe umfassendes Oxid enthält.

4. Solarzelle nach Anspruch 3, wobei die Zwischenschicht (52a, 54a) mindestens eine von einer Siliciumoxidschicht, einer Aluminiumoxidschicht und einer Hafniumoxidschicht umfasst.

5. Solarzelle nach einem der vorhergehenden Ansprüche, wobei für die Zwischenschicht (52a, 54a) mindestens eines der folgenden erfüllt ist:
eine Dicke der Zwischenschicht (52a, 54a) ist gleich oder geringer als eine Dicke der Tunnelschicht (52, 54); und
eine Dicke der Zwischenschicht (52a, 54a) ist gleich oder kleiner als 1 nm.

6. Solarzelle nach einem der vorhergehenden Ansprüche, wobei die Metalloxidschicht des ersten leitfähigen Bereichs (20) ein binäres Metalloxid enthält oder
wobei die Tunnelschicht (52, 54) eine hydrierte Siliciumoxidschicht oder eine hydrierte intrinsische amorphe Siliciumschicht umfasst.

7. Solarzelle nach einem der vorhergehenden Ansprüche, wobei die Tunnelschicht (52, 54) hydrophob ist und die Zwischenschicht (52a, 54a) hydrophil ist.

8. Solarzelle nach einem der vorhergehenden Ansprüche, ferner umfassend:
einen zweiten leitfähigen Bereich (30) zum Extrahieren eines zweiten Trägers, wobei eine Polarität des ersten Trägers von einer Polarität des zweiten Trägers verschieden ist; und
eine zweite Elektrode (44), die elektrisch mit dem zweiten leitfähigen Bereich (30) verbunden ist,
wobei der zweite leitfähige Bereich (30) eine Metalloxidschicht enthält, die eine amorphe Struktur umfasst.

9. Solarzelle nach Anspruch 8, wobei der erste leitfähige Bereich (20) und der zweite leitfähige Bereich (30) koplanar auf der Tunnelschicht (52, 54) sind; oder wobei die Solarzelle ferner eine weitere Tunnelschicht auf der anderen Oberfläche des Halbleitersubstrats (10) und eine weitere Zwischenschicht auf der weiteren Tunnelschicht umfasst, wobei die weitere Zwischenschicht eine Hydroxygruppe umfasst, wobei der zweite leitfähige Bereich (30) und die zweite Elektrode (44) auf der weiteren Zwischenschicht angeordnet sind.

10. Verfahren zur Herstellung einer Solarzelle, umfassend:
Bilden einer Tunnelschicht (52, 54) auf einer Oberfläche eines Halbleitersubstrats (10);
Bilden einer Zwischenschicht (52a, 54a) auf der Tunnelschicht (52, 54);
Bilden eines ersten leitfähigen Bereichs (20), der eine Metalloxidschicht umfasst, die eingerichtet ist zum Extrahieren eines ersten Trägers auf der Zwischenschicht (52a, 54a); und
Bilden einer ersten Elektrode (42), die elektrisch mit dem ersten leitfähigen Bereich (20) verbunden ist, **dadurch gekennzeichnet, dass** die Zwischenschicht (52a, 54a) eine Hydroxygruppe (eine OH-Gruppe) enthält.

11. Verfahren nach Anspruch 10, wobei das Bilden der Zwischenschicht (52a, 54a) ein Bilden der Zwischenschicht unter Verwendung eines nasschemischen Oxidationsprozesses umfasst;
wobei das Bilden der Zwischenschicht (52a, 54a) auf der Tunnelschicht (52, 54) nach dem Bilden der Tunnelschicht (52, 54) auf der Oberfläche des Halbleitersubstrats (10) ein Umwandeln mindestens eines Teils der Tunnelschicht (52, 54) in die Zwischenschicht (52a, 54a) unter Verwendung eines Oxidationsprozesses umfasst, bei dem eine Wärmebehandlung in einem Zustand durchgeführt wird, in dem Ozon oder Wasser zugeführt wird; oder
wobei das Bilden der Zwischenschicht (52a, 54a) ein Bilden der Zwischenschicht (52a, 54a) auf der Tunnelschicht (52, 54) unter Verwendung eines Abscheidungsprozesses nach dem Bilden der Tunnelschicht (52, 54) auf der Oberfläche des Halbleitersubstrats (10) umfasst.

12. Verfahren nach Anspruch 10 oder 11, wobei das Bilden der Tunnelschicht (52, 54) ein Bilden der Tunnelschicht (52, 54) in einer Atmosphäre einschließlich Wasserstoff umfasst oder
wobei die Tunnelschicht (52, 54) durch eine nachfolgende Wärmebehandlung in einer Atmosphäre einschließlich Wasserstoff hydriert wird.

13. Verfahren nach einem der Ansprüche 10 bis 12, wobei die Zwischenschicht (52a, 54a) umfasst:
eine Isolierschicht, die ein eine Hydroxygruppe umfassendes Oxid enthält.

14. Verfahren nach Anspruch 13, wobei die Zwischenschicht (52a, 54a) mindestens eine von einer Siliciumoxidschicht, einer Aluminiumoxidschicht oder einer Hafniumoxidschicht umfasst.

15. Verfahren nach einem der Ansprüche 10 bis 14, wobei die Metalloxidschicht des ersten leitfähigen Bereichs (20) ein binäres Metalloxid enthält oder
wobei die Tunnelschicht (52, 54) eine hydrierte Siliciumoxidschicht oder eine hydrierte intrinsische amorphe Siliciumschicht umfasst.

## Revendications

1. Cellule solaire (100), comprenant :
un substrat semi-conducteur (10) ;
une couche de transmission tunnel (52, 54) sur une surface du substrat semi-conducteur (10) ;
une couche intermédiaire (52a, 54a) sur la couche de transmission tunnel ;
une première région conductrice (20) sur la couche intermédiaire (52a, 54a), la première région conductrice (20) comprenant une couche d'oxyde métallique conçue pour extraire un premier porteur de charge ; et
une première électrode (42) qui est électriquement connectée à la première région conductrice,
**caractérisée en ce que** la couche intermédiaire (52a, 54a) comprenant un groupe hydroxyle (un groupe OH).

2. Cellule solaire selon la revendication 1, au moins l'une des conditions suivantes étant remplie :
la couche intermédiaire (52a, 54a) comprenant une première quantité du groupe hydroxyle, la couche de tunnelisation (52, 54) comprenant une seconde quantité du groupe hydroxyle, et la première quantité étant supérieure à la seconde quantité ; et
la couche de tunnelisation (52, 54) étant terminée par hydrogène.

3. Cellule solaire selon l'une quelconque des revendications précédentes, la couche intermédiaire (52a, 54a) comprenant :
une couche isolante qui comprend un oxyde comprenant le groupe hydroxyle.

4. Cellule solaire selon la revendication 3, la couche intermédiaire (52a, 54a) comprenant au moins une couche d'oxyde de silicium et/ou une couche d'oxyde d'aluminium et/ou une couche d'oxyde de hafnium.

5. Cellule solaire selon l'une quelconque des revendications précédentes, au l'une des conditions suivante est remplie pour la couche intermédiaire (52a, 54a) :
une épaisseur de la couche intermédiaire (52a, 54a) est inférieure ou égale à une épaisseur de la couche de tunnelisation (52, 54) ; et
une épaisseur de la couche intermédiaire (52a, 54a) étant inférieure ou égale à 1 nm.

6. Cellule solaire selon l'une quelconque des revendications précédentes, la couche d'oxyde métallique de la première région conductrice (20) comprenant un oxyde métallique binaire, ou la couche de tunnelisation (52, 54) comprenant un oxyde de silicium hydrogénée ou une couche de silicium amorphe intrinsèque hydrogénée.

7. Cellule solaire selon l'une quelconque des revendications précédentes, la couche de tunnelisation (52, 54) étant hydrophobe et la couche intermédiaire (52a, 54a) étant hydrophile.

8. Cellule solaire selon l'une quelconque des revendications précédentes, comprenant en outre :
une seconde région conductrice (30) pour extraire un second porteur de charge,
une polarité du premier porteur de charge étant différente d'une polarité du second porteur de charge ; et
une seconde électrode (44) qui est électroniquement connectée à la seconde région conductrice (30),
la seconde région conductrice (30) comprenant une couche d'oxyde métallique comprenant une structure amorphe.

9. Cellule solaire selon la revendication 8, la première région conductrice (20) et la seconde région conductrice (30) étant coplanaires sur la couche de tunnelisation (52, 54) ; ou
la cellule solaire comprenant en outre une autre couche de tunnelisation sur l'autre face du substrat semi-conducteur (10) et une autre couche intermédiaire sur l'autre couche de tunnelisation, l'autre couche intermédiaire comprenant un groupe hydroxyle, la seconde région conductrice (30) et la seconde électrode (44) étant disposées sur l'autre couche intermédiaire.

10. Procédé de fabrication d'une cellule solaire, comprenant :
la formation d'une couche de tunnelisation (52, 54) sur une surface d'un substrat semi-conducteur (10) ;
la formation d'une couche intermédiaire (52a, 54a) sur la couche de tunnelisation (52, 54) ;
la formation d'une première région conductrice (20) qui comprend une couche d'oxyde métallique conçue pour extraire un premier porteur de charge sur la couche intermédiaire (52a, 54a) ; et
la formation d'une première électrode (42) qui est connectée électriquement à la première région conductrice (20), **caractérisée en ce que** la couche intermédiaire (52a, 54a) comprend un groupe hydroxyle (un groupe OH).

11. Procédé selon la revendication 10, la formation de la couche intermédiaire (52a, 54a) comprenant la formation de la couche intermédiaire à l'aide d'un processus chimique d'oxydation par voie humide ;
la formation de la couche intermédiaire (52a, 54a) sur la couche de tunnelisation (52, 54) comprenant, après la formation de la couche de tunnelisation (52, 54) sur la surface du substrat semi-conducteur (10), la conversion d'au moins une partie de la couche de tunnelisation (52, 54) en couche intermédiaire (52a, 54a) à l'aide d'un processus d'oxydation dans lequel est effectué un traitement thermique dans un état où l'ozone ou l'eau est fournie ; ou
la formation de la couche intermédiaire (52a, 54a) comprenant la couche intermédiaire (52a, 54a) sur la couche de tunnelisation (52, 54) à l'aide d'un procédé de dépôt après la formation de la couche de tunnelisation (52, 54) sur la face du substrat semi-conducteur (10).

12. Procédé selon la revendication 10 ou 11, la formation de la couche de tunnelisation (52, 54) comprenant la formation de la couche de tunnelisation (52, 54) dans l'atmosphère comprenant de l'hydrogène, ou
la couche de tunnelisation (52, 54) étant hydrogénée par un traitement thermique subséquent dans l'atmosphère comprenant de l'hydrogène.

13. Procédé selon l'une quelconque des revendications 10 à 12, la couche intermédiaire (52a, 54a) comprenant :
une couche isolante qui comprend un oxyde comprenant un groupe hydroxyle.

14. Procédé selon la revendication 13, la couche intermédiaire (52a, 54a) comprenant une couche d'oxyde de silicium et/ou une couche d'oxyde d'aluminium et/ou une couche d'oxyde de hafnium.

15. Procédé selon l'une quelconque des revendications 10 à 14, la couche d'oxyde métallique de la première région (20) comprenant un oxyde métallique binaire ou
la couche de tunnelisation (52, 54) comprenant une couche d'oxyde de silicium hydrogéné ou une couche de silicium amorphe intrinsèque hydrogénée.
